# EUROPEAN PATENT SPECIFICATION

(11) **EP 3 809 481 B1**
(45) Date of publication and mention of the grant of the patent: **17.06.2026**
(21) Application number: 20183588.1
(22) Date of filing: 02.07.2020
(51) Int. Cl.: H10K 50/856, H10K 50/86, H10K 59/40, H10K 59/65

(54) **DISPLAY DEVICE**
ANZEIGEVORRICHTUNG
DISPOSITIF D'AFFICHAGE

(30) Priority: 02.08.2019 KR 20190094517
(43) Date of publication of application: 21.04.2021
(73) Proprietor: Samsung Display Co., Ltd., Yongin-si Gyeonggi-do 17113 (KR)
(72) Inventor: Kim, Myung Hwan, 107-1404 Yongin-si, Gyeonggi-do (KR); Kim, Sang Yeol, 909-302 Hwaseong-si, Gyeonggi-do (KR); Lee, Chang Han, 104-2101 Cheonan-si, Chungcheongnam-do (KR); Chung, Ho Ryun, 101-1701 Suwon-si, Gyeonggi-do (KR)
(74) Representative: Dr. Weitzel & Partner

(56) References cited:
- EP-A1- 3 012 820
- WO-A1-2019/131487
- KR-A- 20190 025 587
- US-A1- 2010 090 595
- US-A1- 2017 229 519
- US-A1- 2019 081 118
- US-A1- 2019 115 411

## Description

The present invention relates to a display.

US 2019/115411 A1 describes a display device including a substrate including a display region including a plurality of pixels and a non-display region at one side of the display region, at least one transistor on the substrate, and a light emitting element connected to the transistor.

US 2010/090595 A1 describes a reflection plate allowing the prevention of the generation of stray light, a method of manufacturing the same, and a light-emitting device using such a reflection plate.

US 2017/229519 A1 describes a display device including a first substrate that includes light emitting elements and color elements for respective pixels, in which the color elements are provided over the light emitting elements.

WO 2019/131487 A1 describes a display element including a display region including pixels arranged in a two-dimensional form, each of the pixels including a plurality of sub pixels.

EP 3 012 820 A1 describes a display device substrate with a transparent substrate, a frame portion, a first transparent resin layer, a black matrix and a second transparent resin layer.

KR 2019/0025587 A describes a thin film encapsulation unit, capable of improving contrast even without using a thick polarizing plate, and to an organic light emitting display device including the same.

US 2019/081118 A1 describes a display device including a substrate, a plurality of pixels on the substrate, the plurality of pixels being around a first area and at least partially surrounding the first area, a light-transmissive wire on the substrate and overlapping the first area, and an encapsulation member covering the plurality of pixels.

Displays are apparatuses for displaying an image, and each display includes a display panel such as an organic light-emitting display panel and/or a liquid crystal panel. Displays may include a window for protecting a display panel from an external impact. Particularly, such windows are generally applied to portable electronic devices, for example, such as smart phones and the like. Some portable electronic devices utilize a touch input function. The displays of such portable electronic devices may include a touch panel to perform the touch input function. The window, touch panel, and display panel may be attached to each other through adhesives and/or the like.

The above information disclosed in this Background section is for enhancement of understanding of the background of the present invention, and therefore, it may contain information that does not constitute prior art.

It is the object of the present invention to provide a display in which a viewing angle controlling pattern is embedded in a display panel.

The present disclosure also includes a method of manufacturing a display in which a viewing angle controlling pattern is embedded in a display panel according to an example useful for understanding the present invention.

This object is achieved by the subject matter of independent claim 1. Preferred embodiments are defined in the sub claims.

It should be noted that aspects and features of the present invention are not limited to the above-described aspects and features, and other aspects and features of the present invention will be apparent to those skilled in the art from the following description.

According to independent claim 1, a display inter alia includes: a display member at which a plurality of pixels is defined, the display member including a base substrate, a light-emitting element on the base substrate at each pixel, and a thin film encapsulation layer on the light-emitting element; a viewing angle controlling member on the display member, the viewing angle controlling member including a plurality of viewing angle controlling patterns; and a cover window on the plurality of viewing angle controlling patterns. The plurality of viewing angle controlling patterns is directly on the thin film encapsulation layer.

In an embodiment, the viewing angle controlling patterns may include at least one of a black-based dye and a metal.

In an embodiment, the viewing angle controlling member may further include a light transmission pattern between adjacent ones of the viewing angle controlling patterns, the light transmission pattern including a transparent photosensitive material.

According to the invention, a height of at least one of the viewing angle controlling patterns is substantially equal to three times a pitch between the adjacent ones of the viewing angle controlling patterns.

In an embodiment, at least one of the viewing angle controlling patterns may have a forward-tapered shape, and an inclined angle between a top surface of the thin film encapsulation layer and a side surface of the at least one of the viewing angle controlling patterns may be within a range of 91° to 110°. That is, a top surface of each of the viewing angle controlling patterns may be smaller than a bottom surface of the respective viewing angle controlling patterns. The bottom surface is the surface directed to the thin film encapsulation layer respectively the light-emitting element.

In an embodiment, at least one of the viewing angle controlling patterns may have a reverse-tapered shape, and an inclined angle between a top surface of the thin film encapsulation layer and a side surface of the at least one of the viewing angle controlling patterns may be within a range of 85° to 89°. That is, a top surface of each of the viewing angle controlling patterns may be greater than a bottom surface of the respective viewing angle controlling patterns. The bottom surface is the surface directed to the thin fil encapsulation layer respectively the light-emitting element.

In an embodiment, a height of a surface of at least one of the viewing angle controlling patterns may be less than a height of a surface of the light transmission pattern.

In an embodiment, the surface, that is the top surface, of the at least one of the viewing angle controlling patterns may include a concave shape or a convex shape or another indented or protruding shape.

In an embodiment, a height of a surface of at least one of the viewing angle controlling patterns may be greater than a height of a surface of the light transmission pattern, and the at least one of the viewing angle controlling patterns may partially cover a top surface of the light transmission pattern.

In an embodiment, the light-emitting element may include a first electrode on the base substrate, a second electrode opposite to the first electrode, and a light-emitting layer between the first electrode and the second electrode, and each of the pixels may include a light-emitting area at which a top surface of the first electrode is partially exposed by a pixel definition film (PDL) on the first electrode, a non-emitting area may be defined at a periphery of the light-emitting area, and each of the viewing angle controlling patterns may be at the non-emitting area.

In an embodiment, each of the viewing angle controlling patterns may not overlap with the light-emitting area of an adjacent pixel. In other words, in a plan view onto the display member, each of the viewing angle controlling patterns may be positioned completely outside of the light-emitting area of an adjacent pixel.

In an embodiment, a height of the viewing angle controlling patterns may be greater than a width of the light-emitting area of an adjacent pixel.

In an embodiment, each of the pixels may include a light-exit area including the light-emitting area and a non-exit area at a periphery of the light-exit area, the display may further include a light-barrier pattern at the non-exit area on the cover window, and the light-barrier pattern may overlap with a corresponding one of the viewing angle controlling patterns in a thickness direction.

In an embodiment, the display may further include: long-side edges extending in a first direction; and short-side edges extending in a second direction crossing the first direction. The plurality of viewing angle controlling patterns may have a stripe shape extending in the first direction.

In an embodiment, the viewing angle controlling patterns may be continuously arranged on a border along the long-side edges and the short-side edges.

In an embodiment, the display may further include: long-side edges extending in a first direction; and short-side edges extending in a second direction crossing the first direction. The plurality of viewing angle controlling patterns may have a stripe shape extending in the second direction.

In an embodiment, the display may further include: long-side edges extending in a first direction; and short-side edges extending in a second direction crossing the first direction. The plurality of viewing angle controlling patterns may have a lattice shape extending in the first direction and the second direction.

The display further includes a through-hole extending completely through the display member and the viewing angle controlling member in a thickness direction, and the viewing angle controlling patterns surround the through-hole.

The display further includes: a touch member on the plurality of viewing angle controlling patterns; and may further include a polarization layer on the touch member.

According to an example useful for understanding the present invention, a display includes: a display member at which a plurality of pixels are defined, the display member including a base substrate, a light-emitting element on the base substrate at each pixel, and a thin film encapsulation layer on the light-emitting element; a touch member on the display member; a polarization layer on the touch member; a viewing angle controlling member on the display member, the viewing angle controlling member including a plurality of viewing angle controlling patterns; and a cover window on the plurality of viewing angle controlling patterns. The light-emitting element includes: a first electrode on the base substrate; a second electrode opposite to the first electrode; and a light-emitting layer between the first electrode and the second electrode. Each of the pixels includes a light-emitting area at which a top surface of the first electrode is partially exposed by a pixel definition film on the first electrode, a non-emitting area is defined at a periphery of the light-emitting area, and each of the viewing angle controlling patterns is at the non-emitting area. Each of the viewing angle controlling patterns does not overlap with the light-emitting area of an adjacent pixel. In other words, in a plan view onto the display member, each of the viewing angle controlling patterns may be positioned completely outside of the light-emitting area of an adjacent pixel.

In an embodiment, the viewing angle controlling patterns may include at least one of a black-based dye, a black-based pigment, and a metal.

In an embodiment, the viewing angle controlling member may further include a light transmission pattern between adjacent ones of the viewing angle controlling patterns, the light transmission pattern including a transparent photosensitive material.

In an embodiment, the viewing angle controlling member may be between the touch member and the polarization layer, or the viewing angle controlling member may be between the polarization layer and the cover window.

According to an example useful for understanding the present invention, a method of manufacturing a display inter alia includes: providing a display member including a base substrate, a light-emitting element on the base substrate in each pixel, and a thin film encapsulation layer on the light-emitting element; forming a photoresist directly on the thin film encapsulation layer; forming a plurality of light transmission patterns by exposing the photoresist to light and developing the exposed photoresist; and forming a viewing angle controlling pattern between adjacent ones of the light transmission patterns. The viewing angle controlling pattern is in direct contact with the thin film encapsulation layer.

In an example, the exposing of the photoresist may include positively exposing the photoresist using a mask, or negatively exposing the photoresist using a mask.

In an example, the forming of the viewing angle controlling pattern between adjacent ones of the light transmission patterns may include forming the viewing angle controlling pattern between adjacent ones of the light transmission patterns through an inkjet process or through a filling process using a black-based material.

Other aspects and features of exemplary embodiments or example are included in the detailed description with reference to the attached drawings.

The above and other aspects and features of the present invention will become more apparent to those skilled in the art from the following detailed description of the illustrative, non-limiting exemplary embodiments with reference to the attached drawings, in which:
FIG. 1 is a perspective view of a display according to an embodiment;
FIG. 2 is a cross-sectional view of the display taken along the line II-II' of FIG. 1;
FIG. 3 is a more detailed cross-sectional view of the display of FIG. 2;
FIG. 4 is an arrangement plan view of the display according to an embodiment;
FIG. 5 is a more detailed cross-sectional view of the display of FIG. 3;
FIG. 6 is an arrangement plan view of a touch member according to an embodiment.
FIG. 7 is a cross-sectional view illustrating a thin film encapsulation layer, a viewing angle controlling member, and the touch member according to an embodiment;
FIG. 8 is a cross-sectional view illustrating a thin film encapsulation layer, a viewing angle controlling member, and a touch member according to an embodiment;
FIG. 9 is a cross-sectional view illustrating a thin film encapsulation layer, a viewing angle controlling member, and a touch member according to an embodiment;
FIG. 10 is a cross-sectional view illustrating a thin film encapsulation layer, a viewing angle controlling member, and a touch member according to an embodiment;
FIG. 11 is a cross-sectional view illustrating a thin film encapsulation layer, a viewing angle controlling member, and a touch member according to an embodiment;
FIG. 12 is a cross-sectional view illustrating a thin film encapsulation layer, a viewing angle controlling member, and a touch member according to an embodiment;
FIGS. 13-16 are cross-sectional views of a plurality of processing operations of a method of manufacturing a display according to an example;
FIGS. 17-18 are cross-sectional views of a plurality of processing operations of a method of manufacturing a display according to an example;
FIG. 19 is a cross-sectional view illustrating a processing operation of the method of manufacturing the display according to an example;
FIG. 20 is a perspective view of a display according to an embodiment;
FIG. 21 is a cross-sectional view of the display taken along the line XXII-XXII' of FIG. 20;
FIG. 22 is a cross-sectional view of a display according to an embodiment different from the present invention;
FIG. 23 is a cross-sectional view of a display according to an embodiment different from the present invention;
FIG. 24 is a cross-sectional view of a display according to an embodiment;
FIG. 25 is an arrangement plan view of a display according to an embodiment; and
FIG. 26 is an arrangement plan view of a display according to an embodiment.

Hereinafter, example embodiments and examples will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof may not be repeated.

In the drawings, the relative sizes of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," and "including," "has, " "have, " and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively. Also, the term "exemplary" is intended to refer to an example or illustration.
Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

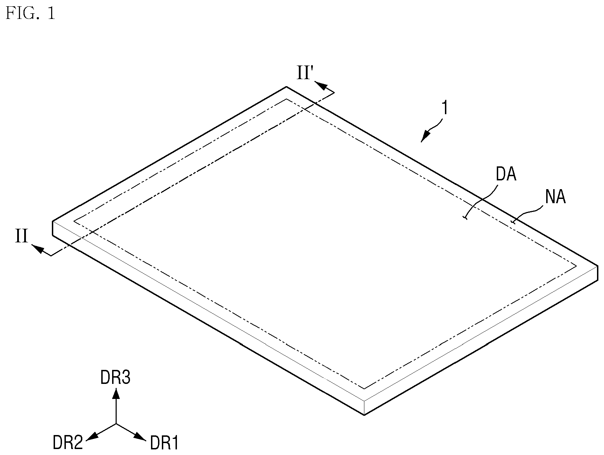

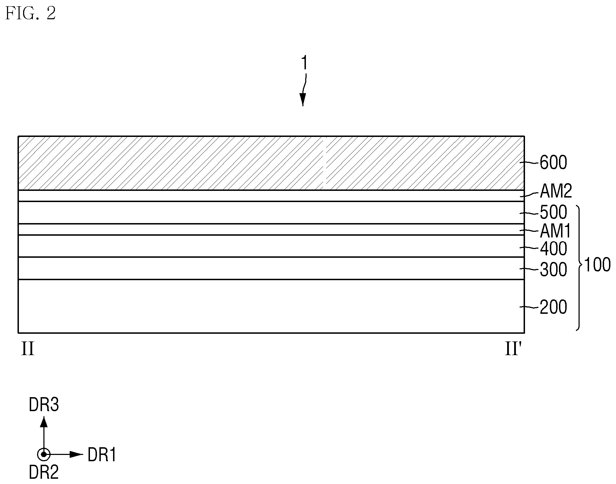

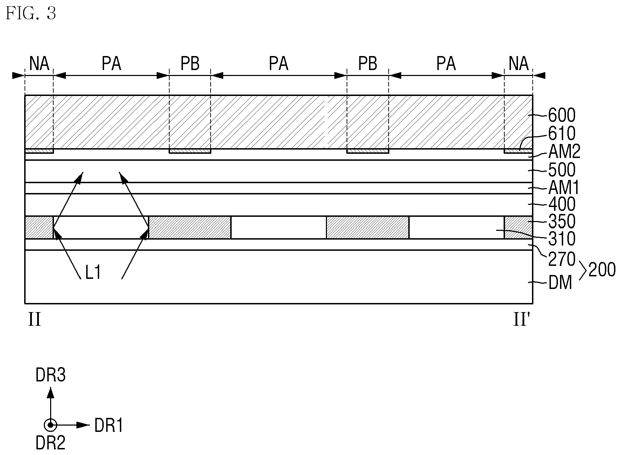

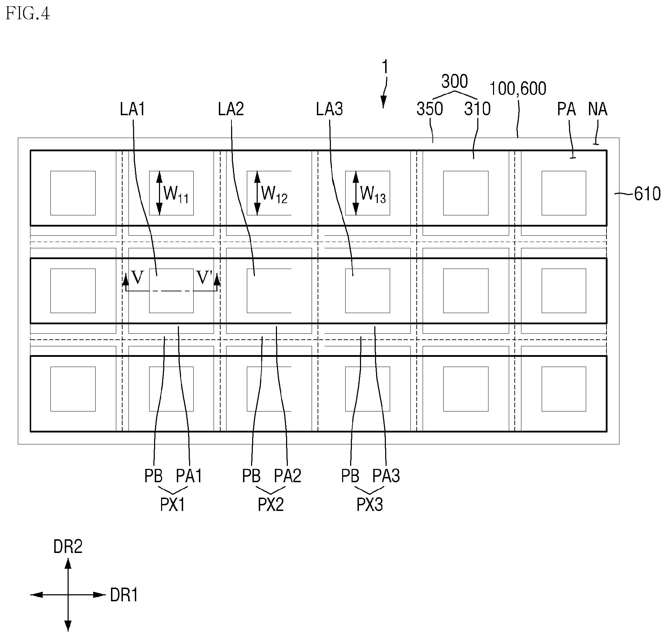

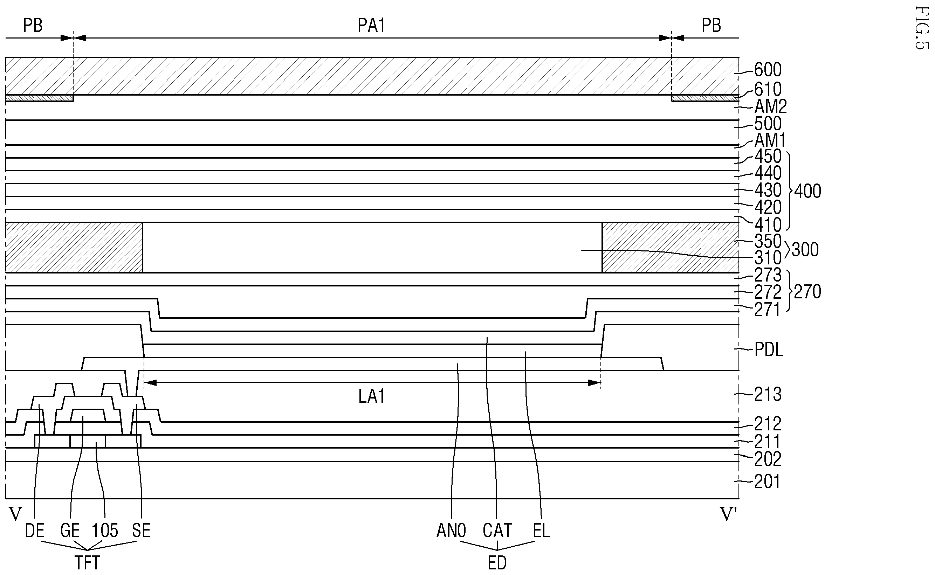

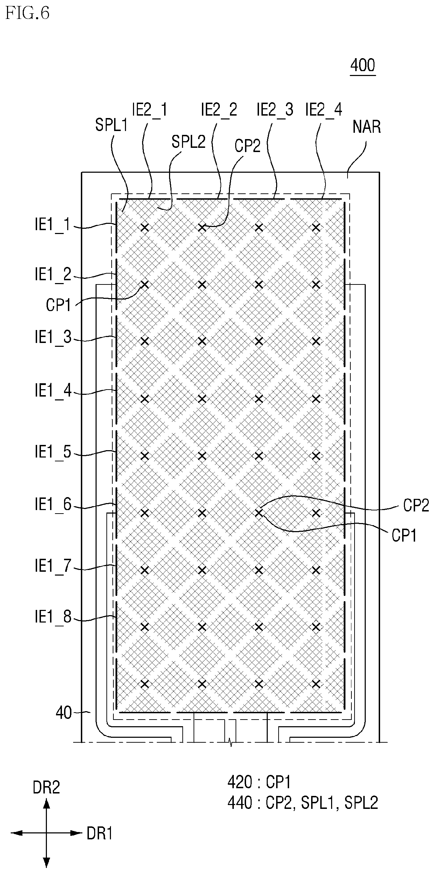

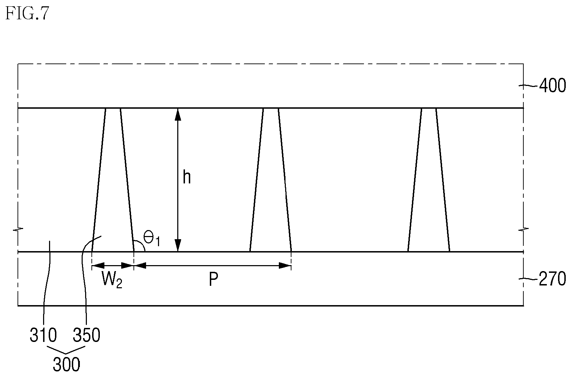

FIG. 1 is a perspective view of a display device according to an embodiment. FIG. 2 is a cross-sectional view of the display device taken along the line II-II' of FIG. 1. FIG. 3 is a more detailed cross-sectional view of the display of FIG. 2. FIG. 4 is an arrangement plan view of the display according to an embodiment. FIG. 5 is a more detailed cross-sectional view of the display of FIG. 3. FIG. 6 is an arrangement plan view of a touch member according to an embodiment. FIG. 7 is a cross-sectional view illustrating a thin film encapsulation layer, a viewing angle controlling member, and the touch member according to an embodiment.

As used herein, a display (e.g., a display 1) is a device that displays a moving picture or a still image, and may be used as a display screen of a variety of products, for example, such as for various portable electronic devices and/or for various display devices. Examples of such portable electronic devices may include a mobile phone, a smart phone, a tablet personal computer (PC), a smart watch, a watch phone, a mobile communication terminal, an electronic notebook, an electronic book, a portable multimedia player (PMP), a navigation system, an ultra-mobile PC, and/or the like. Example of such display devices may include a television, a laptop PC, a monitor, an advertising panel, an Internet of Things (IoT) device, and/or the like. In an exemplary embodiment, the display 1 may be a display for a vehicle (e.g., a vehicular display), but the present invention is not limited thereto.

Referring to FIGS. 1 to 7, the display 1 may have a rectangular shape in a plan view. As used herein, a plan view may refer to a view from a plane that is perpendicular to or substantially perpendicular to (e.g., or normal to) a top surface of the relevant component, element, layer, region, area, and/or the like (e.g., a top surface of the display 1). When a rectangular shape is applied as a planar shape (e.g., a shape when viewed from the plan view) of the display 1, the display 1 may include a plurality of long-side edges extending along a first direction DR1 and a plurality of short-side edges extending along a second direction DR2 that crosses the first direction DR1. Corners where the long-side edges are connected to (e.g., contact or meet with) the short-side edges may have an angular shape as shown in FIG. 1, but the present invention is not limited thereto, and one or more of the corners may have a rounded shape. However, the present invention is not limited to the rectangular shape as the planar shape of the display 1, and in some embodiments, the planar shape of the display 1 may include any suitable or desired shape, for example, such as a square shape, a circular shape, an elliptical shape, other polygonal shapes, and/or the like.

The display 1 may include a display area DA located at (e.g., in or on) a central part (e.g., a central area) of the display 1 in a plan view, and a non-display area NDA located at (e.g., in or on) a periphery of the display area DA. For example, in some embodiments, the non-display area NDA may surround (e.g., around a periphery of) the display area DA. The non-display area NA may be a bezel area, which does not display an image. The display area DA may be an area including a plurality of pixels, and displays an image.

A planar shape (e.g., a shape when viewed from a plan view) of the display area DA may be the same or substantially the same as (e.g., generally equal to or substantially similar to) the shape (e.g., the planar shape) of the display 1. In other words, in an embodiment, the planar shape of the display area DA may be a rectangular shape with angular corners. In this case, the non-display area NA may be disposed along each of (e.g., on all of) a plurality of long-side edges and a plurality of short-side edges of the display area DA to be disposed (e.g., continuously disposed) at (e.g., on) an edge area (e.g., a bezel area) of the display 1, but the present invention is not limited thereto. For example, in various embodiments, the non-display area NA may be disposed along (e.g., in or on) only one long-side edge, one short-side edge, one long-side edge and one short-side edge, both long-side edges, both short-side edges, and/or the like of the display 1.

The display 1 includes a display panel 100, and a cover window 600 disposed on the display panel 100 to cover and protect the display panel 100. The display panel 100 includes a display member 200, a viewing angle controlling member 300 disposed on the display member 200, a touch member 400 disposed on the viewing angle controlling member 300, and an optical film 500 disposed on the touch member 400.

The touch member 400 and the optical film 500 may be coupled with each other through a first optically transparent adhesive member AM1 that is interposed therebetween, and the optical film 500 and the cover window 600 may be coupled with each other through a second optically transparent adhesive member AM2 that is interposed therebetween. In other words, the first optically transparent adhesive member AM1 may connect (e.g., or attach) the touch member 400 and the optical film 500 to each other, and the second optically transparent adhesive member AM2 may connect (e.g., or attach) the optical film 500 and the cover window 600 to each other. Each of the first optically transparent adhesive member AM1 and the second optically transparent adhesive member AM2 may include an optically transparent adhesive film, an optically transparent adhesive tape, an optically transparent resin, and/or the like.

The display panel 100 is a panel which displays an image according to an input data signal. For example, in an embodiment, the display panel 100 may include an organic light-emitting display panel. However, while the organic light-emitting display panel is described in the following embodiments as a non-limiting example of the display panel 100, the present invention is not limited thereto, and any other suitable kinds of display panels may be applied as the display panel 100 as would be known to those skilled in the art, for example, such as a liquid crystal display (LCD) panel, a quantum dot organic light emitting diode (QD-OLED) display panel, a QD-LCD panel, a quantum nano light emitting diode (LED) panel, a micro LED panel, and/or the like.

The display area DA of the display member 200 includes a plurality of pixels. Each pixel may include a light-emitting layer, and a circuit layer that controls a light-emitting quantity of the light-emitting layer. The circuit layer may include a display wiring, a display electrode, and at least one transistor. The light-emitting layer may include an organic light-emitting material. The light emitting layer may be sealed by an encapsulation film. The encapsulation film may prevent or substantially prevent humidity and/or the like from penetrating (e.g., or from flowing) into the light emitting layer from the outside by sealing the light-emitting layer. The encapsulation film may include a single layer inorganic film or lamination film, or a multilayered inorganic film or lamination film that is formed by alternately laminating an inorganic film and an organic film.

The non-display area NA of the display member 200 may include a driving wiring that is connected to the display wiring of the pixel, and a pad (e.g., a driving wiring pad) of the driving wiring. One or more external components, for example, such as a driving chip, a printed circuit board (PCB), and/or the like, may be mounted on the driving wiring pad as described in more detail below.

A thin film encapsulation layer 270 may be disposed on an upper part (e.g., on an uppermost part) of the display member 200. For example, the thin film encapsulation layer 270 may be disposed on light-emitting elements of the display member 200, and may cover the light-emitting elements. The thin film encapsulation layer 270 may include (or may be) a lamination film formed by alternately laminating an inorganic film and an organic film. For example, the thin film encapsulation layer 270 may include a first inorganic encapsulation film 271 (refer to FIG. 5), an organic encapsulation film 272 (refer to FIG. 5), and a second inorganic encapsulation film 273 (refer to FIG. 5), which are sequentially laminated.

Hereinafter, the components of the display member 200 may be referred to as lower display members DM, except for the thin film encapsulation layer 270.

A more detailed description of the display member 200 will be set forth below.

The touch member 400 may be disposed on the display member 200. The touch member 400 may sense a touch pressure. The touch member 400 may be provided in the form of a touch layer inside the display panel 100. However, the present invention is not limited thereto, and while a case in which the touch member 400 is provided inside the display panel 100 is described as an example in the following embodiment, the touch member 400 may be provided as a separate panel or film and attached to the display panel 100 as would be understood by those skilled in the art.

A more detailed description of the touch member 400 will be set forth below.

The optical film 500 may be disposed on the touch member 400. The optical film 500 may include a plurality of laminated films. For example, the optical film 500 may include a lower protection film disposed on the touch member 400, a phase-delay film disposed on the lower protection film, a polarization layer disposed on the phase-delay film, and an upper protection film disposed on the polarization layer.

The upper protection film and the lower protection film may protect the polarization layer and the phase-delay film from external humidity, foreign substances, and/or the like. The upper protection film and the lower protection film may include an organic insulating material.

The phase-delay film may shift a phase of light. For example, the phase-delay film may include (or may be) a λ/4 (e.g., a quarter-wave) phase-delay film. The phase-delay film may include a double-refractive film including a polymer, an orientation film of a liquid polymer, a film including an orientation layer of a liquid polymer, and/or the like.

The polarization layer may selectively transmit light. For example, the polarization layer may include (or may be) a linear polarization layer. The polarization layer may include (or may be) a polyvinyl alcohol (PVA) film. The polarization layer may be manufactured by elongating the PVA film in a desired direction (e.g., in one direction or in an elongation direction), and then adsorbing iodine (I) and/or a dichromatic dye therein. In this case, the polarization layer may have an absorption axis in the elongation direction, and a transmission axis in a direction perpendicular to or substantially perpendicular to (or normal to) an absorption axis. Accordingly, linear polarized light from among light that is incident on the polarization layer (e.g., only the linear polarized light) is emitted in a direction that is parallel to or substantially parallel to the transmission axis.

The cover window 600 is disposed above (e.g., on) the display panel 100. The cover window 600 is disposed above the display panel 100 to protect the display panel 100, while transmitting light that is emitted from the display panel 100. The cover window 600 may include glass and/or the like.

The cover window 600 may be disposed to overlap with the display panel 100, and may cover an entire surface of the display panel 100. In some embodiments, the cover window 600 may be larger than the display panel 100. For example, in some embodiments, the cover window 600 may protrude further outwardly from both short sides of the display 1 than the display panel 100.

The viewing angle controlling member 300 is disposed between the display member 200 and the touch member 400. As shown in FIG. 3, the viewing angle controlling member 300 may include light transmission patterns 310, and viewing angle controlling patterns 350 that are disposed between adjacent ones of the light transmission patterns 310.

The light transmission patterns 310 may transmit light emitted by the light-emitting elements to allow a user to recognize the light. The light transmission patterns 310 may include a transparent material. The transparent material may include, for example, a resin and/or a transparent photosensitive material. The resin may include, for example, polyethylene terephthalate (PET), polyacrylate, polyimide (PI), polycarbonate (PC), and/or the like. The transparent photosensitive material may include (or may be), for example, a photoresist. According to an embodiment, the light transmission pattern 310 may include a photoresist.

The viewing angle controlling pattern 350 may adjust a viewing angle (e.g., a particular viewing angle) to prevent or substantially prevent light that is emitted by the light-emitting element from being emitted wider than a desired angle (e.g., a particular angle or a threshold angle) that may be recognized by the user. The viewing angle controlling pattern 350 may, for example, convert an optical path by reflecting a first light ray L1 that is emitted from the light-emitting element to adjust the viewing angle (e.g., the particular viewing angle). The viewing angle controlling pattern 350 may include a light-barrier material and/or a light-reflecting material. The light barrier material may include various suitable materials, for example, such as a dark-colored pigment (e.g., a black pigment and/or a gray pigment), a dark-colored dye (e.g., a black dye and/or a gray dye), carbon black, a photoresist, and/or the like. The light-reflecting material may include various suitable materials, for example, such as a metal material (e.g., aluminum (Al) and/or silver (Ag)).

Each pixel of the display 1 may include a light-exit area PA, and a non-exit area PB (which may be also termed as a blocking area) located at (e.g., on) a periphery of (e.g., or located adjacent to) the light-exit area PA. The light-exit area PA and the non-exit area PB may be divided by a light-barrier member 610, which will be described in more detail below. The light-barrier member 610 may be disposed on a bottom surface of the cover window 600. For example, the light-barrier member 610 may be printed on (e.g., printed directly on) the bottom surface of the cover window 600. The light-barrier member 610 may be disposed over the non-exit area PB and the non-display area NA, and may not be disposed at (e.g., in or on) the light-exit area PA, that is, may be positioned completely outside of the light-exit area PA, when viewed in a plan view.

The above-described viewing angle controlling pattern 350 may be disposed to overlap with the light-barrier member 610 in a thickness direction (e.g., in a direction that is parallel or substantially parallel to (e.g., or normal with) a top surface of the display 1). The viewing angle controlling pattern 350 may be disposed at (e.g., in or on) the non-display area NA and the non-exit area PB. As shown in FIG. 3, in some embodiments, the viewing angle controlling pattern 350 may be disposed to extend to the light-exit area PA that is adjacent to the non-exit area PB. For example, in some embodiments, the viewing angle controlling pattern 350 may partially overlap with the light-exit area PA. In other words, the viewing angle controlling pattern 350 may be disposed at (e.g., in or on) the non-exit area PB, and at (e.g., in or on) a part (or a portion) of the light-exit area PA. The viewing angle controlling pattern 350 may have a width that is greater than a width of the light-barrier member 610 at (e.g., in or on) the display area DA. In other words, side surfaces (e.g., opposite end surfaces shown in FIG. 3) of the viewing angle controlling pattern 350 may be located further outside than side surfaces (e.g., opposite end surfaces shown in FIG. 3) of the light-barrier member 610 in a plan view.

Referring to FIG. 4, a plurality of pixels PX1, PX2, and PX3 of the display area DA may include a first pixel PX1 to emit a first color light (for example, a red color light having a wavelength peak within a range of about 610 nm to about 650 nm), a second pixel PX2 to emit a second color light (for example, a green color light having a wavelength peak within a range of about 510 nm to about 550 nm), and a third pixel PX3 to emit a third color light (for example, a blue color light having a wavelength peak within a range of about 430 nm to about 470 nm). The first pixel PX1, the second pixel PX2, and the third pixel PX3 may be alternately arranged with each other in a row direction and/or a column direction. The plurality of pixels PX1, PX2, and PX3 may have various suitable arrangements, for example, such as a stripe type arrangement, a pentile type arrangement, and/or the like.

The pixels PX1, PX2, and PX3 may include light-exit areas PA1, PA2, and PA3, respectively, and non-exit areas PB. As used herein, the light-exit areas PA1, PA2, and PA3 are defined as areas in which light exits through a display surface, and the non-exit areas PB are defined as areas in which light does not exit through the display surface. The non-exit areas PB may be arranged to surround (e.g., around a periphery of) the light-exit areas PA1, PA2, and PA3.

The light-barrier member 610 may be disposed at (e.g., in or on) the non-display area NA and the non-exit areas PB, and the viewing angle controlling patterns 350 may be disposed at (e.g., in or on) the non-display area NA and the non-exit areas PB. The light-barrier member 610 may have a lattice shape in a plan view. The viewing angle controlling patterns 350 may be arranged along the non-display area NA, for example, at an edge (or a bezel) of the display 1, and may have a stripe shape extending along the first direction DR1.

The light-exit areas PA1, PA2, and PA3 may further include light-emitting areas LA1, LA2, and LA3, respectively. Non-emitting areas may be arranged at (e.g., on) a periphery of the light-emitting areas LA1, LA2, and LA3. As used herein, the light-emitting areas LA1 to LA3 may be defined as areas of the pixels PX1 to PX3 in which a first electrode ANO (e.g., refer to FIG. 5, and which will be described in more detail below) is exposed by a pixel definition film PDL. The viewing angle controlling patterns 350 may be disposed between the light-emitting areas LA1 to LA3 of the pixels PX1 to PX3, which are disposed to be adjacent to each other along the second direction DR2. The viewing angle controlling patterns 350 may be disposed to not overlap with the light-emitting areas LA1 to LA3 of the respective pixels PX1 to PX3, and to overlap with the non-emitting areas of the respective pixels PX1 to PX3.

The light-emitting areas LA1 to LA3 of the pixels PX1 to PX3 may have a first width W1. The widths of the light-emitting areas LA1 to LA3 may be different from each other or may be equal or substantially equal to each other. For example, a first light-emitting area LA1 may have a first-first width W11, a second light-emitting area LA2 may have a first-second width W12, and a third light-emitting area LA3 may have a first-third width W13. Although it is shown in FIG. 4 that the first width W1 is a width that extends in the second direction DR2, the present invention is not limited thereto, and the first width W1 may refer to a width of a part in which the width of each of the light-emitting areas LA1 to LA3 is the greatest. For example, the first-first width W11 of the first light-emitting area LA1 may be equal to the first-second width W12 of the second light-emitting area LA2, and the first-first width W11 of the first light-emitting area LA1 may be less than the first-third width W13 of the third light-emitting area LA3.

The light transmission pattern 310 may be disposed at (e.g., in or on) an area of the display area DA of the display 1 at (e.g., in or on) which the viewing angle controlling pattern 350 is not disposed. The light transmission pattern 310 may be surrounded (e.g., around a periphery thereof) by the adjacent viewing angle controlling pattern 350.

Referring to FIG. 5, the display member 200 includes a base substrate 201, and may include a plurality of conductive layers, a plurality of insulating layers insulating the conductive layers, an organic layer EL, and the like.

The base substrate 201 is disposed over an entirety of the display area DA and the non-display area NA. The base substrate 201 may support a variety of elements that are disposed thereon (e.g., that are disposed above the base substrate 201). The base substrate 201 may be a flexible substrate or a semiflexible substrate including a partially flexible material (e.g., a semi-flexible material). In this case, the base substrate 201 may include, for example, PET, PI, PC, polyethylene (PE), polypropylene (PP), polysulfone (PSF), poly(methyl methacrylate) (PMMA), triacetyl cellulose (TAC), cyclo olefin polymer (COP), and/or the like.

However, the present invention is not limited thereto, and in some embodiments, the base substrate 201 may be a rigid substrate including a rigid material, for example, such as glass (e.g., flexible glass), quartz, and/or the like.

The buffer layer 202 may be disposed on the base substrate 201. The buffer layer 202 may prevent or substantially prevent humidity and/or oxygen from penetrating from the outside through the base substrate 201. The buffer layer 202 may planarize a surface of the base substrate 201. In an embodiment, the buffer layer 202 may include any suitable one from among a silicon nitride (SiNx) film, a silicon oxide (SiO₂) film, and a silicon oxynitride (SiOₓN_{y}) film.

A semiconductor layer 105 may be disposed on the buffer layer 202. The semiconductor layer 105 forms a channel of a thin film transistor (TFT). The semiconductor layer 105 may be disposed at (e.g., in or on) each pixel of the display area DA, and in some embodiments, may be further disposed even at (e.g., in or on) the non-display area NA as needed or desired (e.g., as the occasion demands). The semiconductor layer 105 may include a source/drain area and an active area. The semiconductor layer 105 may include polycrystalline silicon.

A first insulating layer 211 may be disposed on the semiconductor layer 105. The first insulating layer 211 may be disposed on an entire surface of the base substrate 201. The first insulating layer 211 may include (or may be) a gate insulating film having a gate insulating function. The first insulating layer 211 may include one or more of a silicon compound, a metal oxide, and/or the like. For example, the first insulating layer 211 may include silicon oxide, silicon nitride, silicon oxynitride, Al oxide, tantalum (Ta) oxide, hafnium (Hf) oxide, zirconium (Zr) oxide, titanium (Ti) oxide, and/or the like. In some embodiments, one or more of the above described materials that may be included in the first insulating layer 211 may be used alone or in combination with each other.

A gate electrode GE of the TFT may be disposed on the first insulating layer 211. The gate electrode GE may include at least one selected from among molybdenum (Mo), Al, platinum (Pt), palladium (Pd), Ag, magnesium (Mg), gold (Au), nickel (Ni), neodymium (Nd), iridium (Ir), chrome (Cr), calcium (Ca), Ti, tungsten (W), and copper (Cu). The gate electrode GE may be a single film or a lamination film, which may be formed of one or more of the above-exemplified materials.

A second insulating layer 212 may be disposed on the gate electrode GE of the TFT. The second insulating layer 212 may insulate the gate electrode GE, a source electrode SE, and a drain electrode DE of the TFT. The second insulating layer 212 may include one or more materials selected from among the above-exemplified materials of the first insulating layer 211 described above.

The source electrode SE and the drain electrode DE may be disposed on the second insulating layer 212. The source electrode SE and the drain electrode DE may include (or may be) a single film formed of one or more of the above-exemplified materials of the gate electrode GE described above. However, the source electrode SE and the drain electrode DE are not limited thereto, and the source electrode SE and the drain electrode DE may be a lamination film. For example, each of the source electrode SE and the drain electrode DE may have a lamination structure of Ti/Al/Ti, Mo/Al/Mo, Mo/AlGe/Mo, Ti/Cu, and/or the like. The source electrode SE and the drain electrode DE may be in contact with the source area and the drain area, respectively, of the semiconductor layer 105 through respective contact holes that extend (e.g., that pass) through the first insulating layer 211 and the second insulating layer 212.

A third insulating layer 213 may be disposed on the source electrode SE and the drain electrode DE. The third insulating layer 213 may include one or more organic insulating materials, for example, such as polyacrylate resin, epoxy resin, phenolic resin, polyamide resin, polyimide resin, unsaturated polyesters resin, poly phenylenether resin, polyphenylenesulfide resin, benzocyclobutene (BCB), and/or the like. In some embodiments, the third insulating layer 213 may include at least one of the above-exemplified materials of the first insulating layer 211 described above.

The source electrode SE, the drain electrode DE, the gate electrode GE, and the semiconductor layer 105 may form the TFT.

The first electrode ANO is disposed on the third insulating layer 213. The first electrode ANO may be an anode electrode. The first electrode ANO may be electrically connected to the source electrode SE through a contact hole that extends (e.g., passes) through the third insulating layer 213.

The pixel definition film PDL may be disposed on the first electrode layer ANO. The pixel definition film PDL may include an opening that exposes the first electrode layer ANO. The pixel definition film PDL may include an organic insulating material or an inorganic insulating material. In an embodiment, the pixel definition film PDL may include any suitable material, for example, such as a photoresist, a polyimide resin, an acrylic resin, a silicon compound, a polyacrylic resin, and/or the like.

The organic layer EL may be disposed on a top surface of the first electrode ANO, and at (e.g., in or on) the opening of the pixel definition film PDL. A second electrode CAT is disposed on the organic layer EL and the pixel definition film PDL. The second electrode CAT may be a cathode electrode. The cathode electrode CAT may be a common electrode that is disposed over an entirety of the plurality of pixels. The first electrode ANO, the organic layer EL, and the second electrode CAT may form a light-emitting element ED. Each light-emitting element ED may be disposed for each of the pixels PX1, PX2, and PX3.

The thin film encapsulation layer 270 is disposed on the cathode electrode CAT.

The viewing angle controlling member 300 is disposed on a top surface of the thin film encapsulation layer 270. The viewing angle controlling member 300 may be disposed directly on the top surface of the thin film encapsulation layer 270. In other words, bottom surfaces of the viewing angle controlling pattern 350 and the light transmission pattern 310 may be disposed directly on a top surface of the second inorganic film 273 of the thin film encapsulation layer 270.

The touch member 400 may include a first touch insulating layer 410, a first touch conductive layer 420 disposed on the first touch insulating layer 410, a second touch insulating layer 430 disposed on the first touch conductive layer 420, a second touch conductive layer 440 disposed on the second touch insulating layer 430, and a third touch insulating layer 450 disposed on the second touch conductive layer 440. However, the present invention is not limited thereto, and the third touch insulating layer 450 may be omitted as desired.

Referring to FIGS. 5 and 6, the first touch insulating layer 410 may be disposed on the viewing angle controlling member 300. The first touch insulating layer 410 may insulate the first touch conductive layer 420 and a plurality of conductive layers of the display member 200 from each other.

In an embodiment, the first touch insulating layer 410 may include an inorganic insulating material. For example, the inorganic material may include any one or more selected from the group consisting of SiOₓ, SiNx, and SiONₓ. In another embodiment, the first touch insulating layer 410 may include an organic material. For example, the organic material may include at least one of an acrylic resin, a methacrylic resin, polyisoprene, a vinyl-based resin, an epoxy-based resin, a urethane-based resin, a cellulose-based resin, a siloxane-based resin, a polyimide-based resin, a polyamide resin, and a perylene-based resin.

The first touch conductive layer 420 may be disposed on the first touch insulating layer 410. The first touch conductive layer 420 may include first touch bridge electrodes CP1, which electrically connect adjacent ones of first sensing electrodes IE1_1 to IE1_8 to each other. The first touch bridge electrodes CP1 may be disposed to be spaced apart from each other. The first touch bridge electrodes CP1, which are disposed to be spaced apart from each other, may partially expose a top surface of the first touch insulating layer 410. The first touch bridge electrodes CP1 of the first touch conductive layer 420 may overlap with a black matrix and the pixel definition film PDL. Accordingly, the user may be prevented or substantially prevented from recognizing the first touch bridge electrodes CP1.

The second touch insulating layer 430 may be disposed on the first touch conductive layer 420. The second touch insulating layer 430 may be in contact (e.g., in direct contact) with the first touch insulating layer 410 having the exposed top surface. The second touch insulating layer 430 may insulate the first touch conductive layer 420 and the second touch conductive layer 440 from each other. The second touch insulating layer 430 may include an inorganic insulating material. For example, the second touch insulating layer 430 may include at least one of the exemplified materials of the first touch insulating layer 410 described above.

The second touch conductive layer 440 may be disposed on the second touch insulating layer 430. The second touch conductive layer 440 may include the plurality of first sensing electrodes IE1_1 to IE1_8, a plurality of second sensing electrodes IE2_1 to IE2_4, and second touch bridge electrodes CP2 that electrically connect adjacent ones of the second sensing electrodes IE2_1 to IE2_4 to each other.

The plurality of first sensing electrodes IE1_1 to IE1_8 may extend in the second direction DR2, and may be arranged in the first direction DR1. The plurality of second sensing electrodes IE2_1 to IE2_4 may extend in the first direction DR1, and may be arranged in the second direction DR2.

Each of the plurality of first sensing electrodes IE1_1 to IE1_8 may include a plurality of first sensing lines SPL1 that are arranged to have a mesh shape. Areas partitioned by the plurality of first sensing lines SPL1 may overlap with the light-emitting areas LA1, LA2, and LA3 that are disposed at (e.g., in or on) each pixel.

Each of the plurality of second sensing electrodes IE2_1 to IE2_4 may include a plurality of second sensing lines SPL2 that are arranged to have a mesh shape. Areas partitioned by the plurality of second sensing lines SPL2 may also overlap with the light-emitting areas LA1, LA2, and LA3 that are disposed at (e.g., in or on) each pixel. In an embodiment, the areas partitioned by the plurality of first sensing lines SPL1 and the areas partitioned by the plurality of second sensing lines SPL2 may have a diamond shape. As used herein, the diamond shape includes not only a shape that is the same or substantially the same as a diamond shape, but also a shape that is similar to a diamond shape in consideration of a processing procedure, an arrangement shape of sensing lines, and/or the like.

The plurality of first sensing lines SPL1 may be electrically insulated from the plurality of second sensing lines SPL2. In an embodiment, the plurality of first sensing lines SPL1 and the plurality of second sensing lines SPL2 may be disposed at (e.g., on) the same or substantially the same layer. In this case, the plurality of first touch bridge electrodes CP1 and the plurality of second touch bridge electrodes CP2 are disposed at (e.g., on) different layers from each other, and may be electrically insulated from each other.

The second touch bridge electrodes CP2 and the sensing electrodes of the second touch conductive layer 440 may overlap with a black matrix and the pixel definition film PDL. Accordingly, the user may be prevented or substantially prevented from recognizing the second touch bridge electrodes CP2 and the sensing electrodes.

The third touch insulating layer 450 may be disposed on the second touch conductive layer 440. The third touch insulating layer 450 may include an inorganic material or an organic material.

In some embodiments, the electrodes included in the first touch conductive layer 420 and the electrodes included in the second touch conductive layer 440 may be opposite to each other.

In some embodiments, the first touch conductive layer 420 may include the first sensing electrodes IE1_1 to IE1_8 and the first touch bridge electrodes CP1, and the second touch conductive layer 440 may include the second sensing electrodes IE2_1 to IE2_4 and the second touch bridge electrodes CP2.

In some embodiments, the first touch conductive layer 420 may include the second sensing electrodes IE2_1 to IE2_4 and the second touch bridge electrodes CP2, and the second touch conductive layer 440 may include the first sensing electrodes IE1_1 to IE1_8 and the first touch bridge electrodes CP1.

Hereinafter, for convenience, it may be mainly described that the first touch conductive layer 420 includes the first touch bridge electrodes CP1 that electrically connect the adjacent ones of the first sensing electrodes IE1_1 to IE1_8 to each other, and the second touch conductive layer 440 includes the plurality of first sensing electrodes IE1_1 to IE1_8, the plurality of second sensing electrodes IE2_1 to IE2_4, and the second touch bridge electrodes CP2 that electrically connect the adjacent ones of the second sensing electrodes IE2_1 to IE2_4 to each other.

Each of the first touch conductive layer 420 and the second touch conductive layer 440 may include a conductive material. For example, the conductive material may include a low-resistive metal, such as Ag, Al, Cr, Ni, and/or the like, or the conductive material may include a conductive nano-material, such as silver nanowires, carbon nanotubes, and/or the like.

Referring to FIG. 7, the viewing angle controlling patterns 350 may have a forward-tapered shape. In other words, the viewing angle controlling pattern 350 may have a trapezoidal shape in which a width of a bottom surface thereof is greater than a width of a top surface thereof.

The top surface of the viewing angle controlling pattern 350 may be aligned with a top surface of the light transmission pattern 310. However, the present invention is not limited thereto, and the top surface of the viewing angle controlling pattern 350 may protrude upwards from the top surface of the light transmission pattern 310 or may be indented downwards from (e.g., or may be lower than) the top surface of the light transmission pattern 310. The top surface of the viewing angle controlling pattern 350 may have a linear shape.

The viewing angle controlling pattern 350 may have a second width W2 corresponding to a width of the bottom surface thereof, a pitch P between the viewing angle controlling pattern 350 and an adjacent viewing angle controlling pattern 350 on the basis of the bottom surface of the viewing angle controlling pattern 350, and a height h in a thickness direction.

The height h of the viewing angle controlling pattern 350 is equal to or substantially equal to three times the pitch P of the viewing angle controlling pattern 350. When the viewing angle controlling pattern 350 has the forward-tapered shape, a first inclined angle θ1 formed between a side surface of the viewing angle controlling pattern 350 and the top surface of the thin film encapsulation layer 270 is an obtuse angle. For example, the first inclined angle θ1 is equal to or substantially equal to about 91° to about 110°.

The height h of the viewing angle controlling pattern 350 may be greater than the first width W1 of the light-emitting areas LA1, LA2, and LA3 of each pixel.

In the display 1 according to an embodiment, because the viewing angle controlling member 300 including the viewing angle controlling patterns 350 is embedded in the display panel 100, a distance between the light-emitting element ED of each of the pixels PX1, PX2, and PX3 and the viewing angle controlling pattern 350 is reduced, so as to adjust (e.g., more easily adjust) a viewing angle.

Also, because the viewing angle controlling member 300 is disposed on (e.g., directly on) the top surface of the thin film encapsulation layer 270 of the display panel 100 without using an adhesive and/or the like, a transmission loss of light that is emitted by the light-emitting element ED of the display panel 100 is prevented or substantially prevented in advance.

Also, the viewing angle controlling patterns 350 of the viewing angle controlling member 300 is arranged to not overlap with the light-emitting areas LA1, LA2, and LA3 of the adjacent pixels PX1, PX2, and PX3, so that light loss is prevented or substantially prevented in advance.

Hereinafter, a display according to one or more other embodiments will be described. In the following description, components, elements, and/or layers that are the same or substantially the same as those of one or more of the above-described embodiments may be referred to with the same or substantially the same reference symbols, and thus, redundant description thereof may be simplified or may not be repeated.

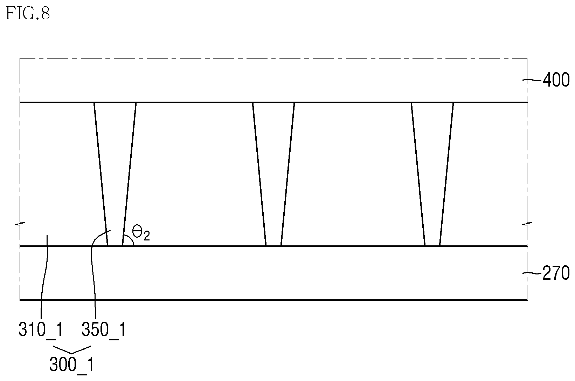

FIG. 8 is a cross-sectional view illustrating a thin film encapsulation layer, a viewing angle controlling member, and a touch member according to an embodiment.

Referring to FIG. 8, a viewing angle controlling member 300_1 may be different from the viewing angle controlling member 300 of FIG. 7 in that a viewing angle controlling pattern 350_1 of the viewing angle controlling member 300_1 of FIG. 8 has a reverse-tapered shape.

When the viewing angle controlling pattern 350_1 has the reverse-tapered shape, a second inclined angle θ2 may be formed between a side surface of the viewing angle controlling pattern 350_1 and the top surface of the thin film encapsulation layer 270. In this case, the second inclined angle θ2 may be an acute angle. For example, the second inclined angle θ2 may be equal to or substantially equal to about 85° to about 89°.

Other components and features in FIG. 8 are the same or substantially the same as those described above with reference to FIG. 7, and thus, redundant description thereof may not be repeated.

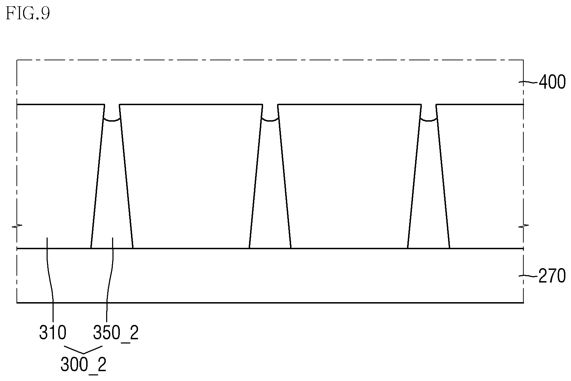

FIG. 9 is a cross-sectional view illustrating a thin film encapsulation layer, a viewing angle controlling member, and a touch member according to an embodiment.

Referring to FIG. 9, a viewing angle controlling member 300_2 according to the embodiment may be different from the viewing angle controlling member 300 of FIG. 7 in that a top surface of a viewing angle controlling pattern 350_2 of the viewing angle controlling member 300_2 in FIG. 9 is indented downwards from the top surface of the light transmission pattern 310. In this case, the top surface of the viewing angle controlling pattern 350_2 may have a concave shape. Other indented shapes without a rounded surface are possible, e.g. a stepped recess.

Other components and features in FIG. 9 are the same or substantially the same as those described above with reference to FIG. 7, and thus, redundant description thereof may not be repeated.

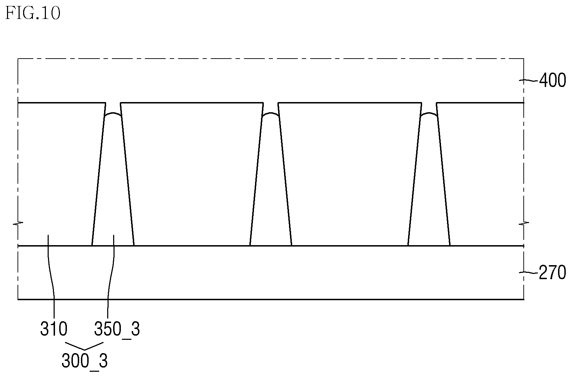

FIG. 10 is a cross-sectional view illustrating a thin film encapsulation layer, a viewing angle controlling member, and a touch member according to an embodiment.

Referring to FIG. 10, a viewing angle controlling member 300_3 according to the embodiment is different from the viewing angle controlling member 300_2 of FIG. 9 in that a viewing angle controlling pattern 350_3 of the viewing angle controlling member 300_3 of FIG. 10 has a convex top surface.

Other components and features in FIG. 10 are the same or substantially the same as those described above with reference to FIGS. 7 and 9, and thus, redundant description thereof may not be repeated.

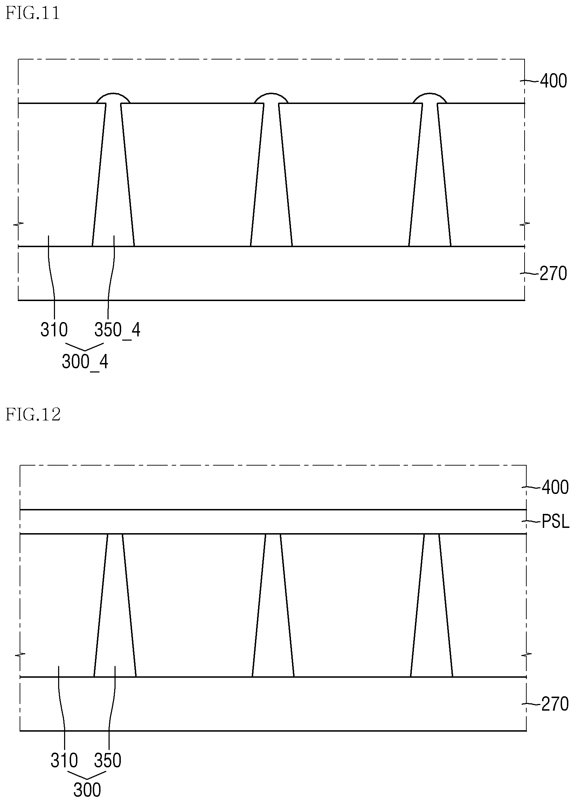

FIG. 11 is a cross-sectional view illustrating a thin film encapsulation layer, a viewing angle controlling member, and a touch member according to an embodiment.

Referring to FIG. 11, a viewing angle controlling member 300_4 according to the embodiment is different from the viewing angle controlling member 300 of FIG. 7 in that a viewing angle controlling pattern 350_4 of the viewing angle controlling member 300_4 of FIG. 11 protrudes upwards from the top surface of the light transmission pattern 310. For example, the viewing angle controlling pattern 350_4 of FIG. 11 may be partially disposed on the top surface of the light transmission pattern 310.

In more detail, a top surface of the viewing angle controlling pattern 350_4 of the viewing angle controlling member 300_4 of FIG. 11 may protrude upwards from the top surface of the light transmission pattern 310, and may partially overlap with the light transmission pattern 310. For example, the top surface of the viewing angle controlling pattern 350_4 may be partially disposed on the top surface of the light transmission pattern 310.

Other components and features in FIG. 11 are the same or substantially the same as those described above with reference to FIG. 7, and thus, redundant description thereof may not be repeated.

FIG. 12 is a cross-sectional view illustrating a thin film encapsulation layer, a viewing angle controlling member, and a touch member according to an embodiment.

Referring to FIG. 12, the embodiment shown is different from the embodiment of FIG. 7 in that a planarization layer PSL is further disposed between the touch member 400 and the viewing angle controlling member 300.

In more detail, the planarization layer PSL may include an organic insulating material. The planarization layer PSL may be disposed on the top surface of the viewing angle controlling member 300, and may planarize the top surface of the viewing angle controlling member 300 such that the touch member 400 may be disposed (e.g., or easily deposited) thereabove.

Other components and features in FIG. 12 are the same or substantially the same as those described above with reference to FIG. 7, and thus, redundant description thereof may not be repeated.

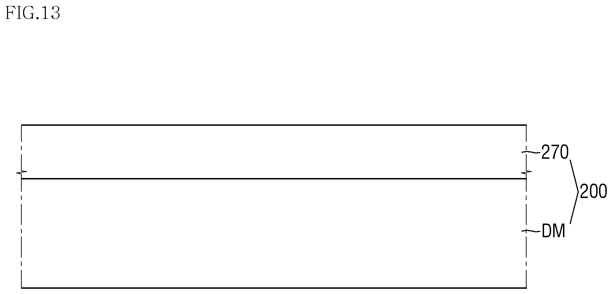

FIGS. 13 to 16 are cross-sectional views of a plurality of processing operations of a method of manufacturing a display according to an example.

Referring to FIG. 13, the display member 200 is provided. In some embodiments, as described above, the display member 200 may include the base substrate 201, the light-emitting element ED disposed on the base substrate 201 for each of the pixels PX1, PX2, and PX3, and the thin film encapsulation layer 270 disposed on the light-emitting element ED.

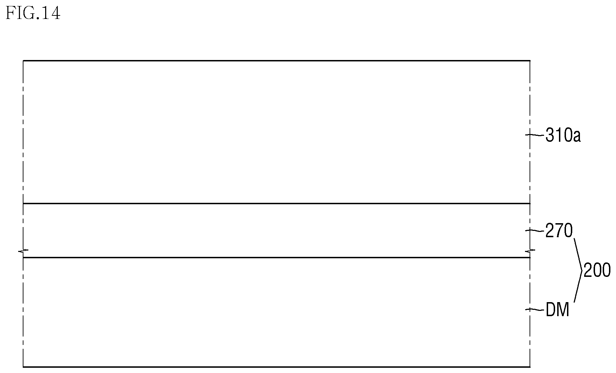

Referring to FIG. 14, a light transmission material 310a may be formed (e.g., may be directly formed) on the thin film encapsulation layer 270. The light transmission material 310a may include a transparent material. The transparent material may include, for example, a resin and/or a transparent photosensitive material. The resin may include, for example, PET, polyacrylate, PI, PC, and/or the like. The transparent photosensitive material may include, for example, a photoresist, and/or the like. The light transmission material 310a according to an embodiment may include a photoresist. For example, the light transmission material 310a may include (or may be) a dry photoresist without a solvent. In this case, the operation of forming the light transmission material 310a may further include an operation of forming the dry photoresist on the thin film encapsulation layer 270 using a lamination process.

However, the present invention is not limited thereto, for example, in some embodiments, the light transmission material 310a may include (or may be) a dry photoresist including a solvent. In this case, the operation of forming the light transmission material 310a may further include an operation of coating the thin film encapsulation layer 270 with a photoresist including a solvent, and removing the solvent.

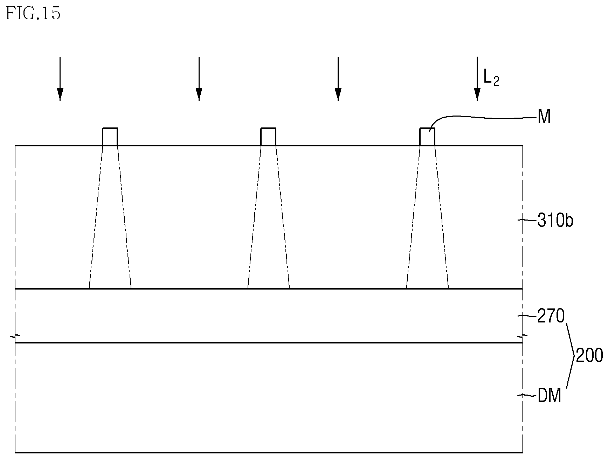

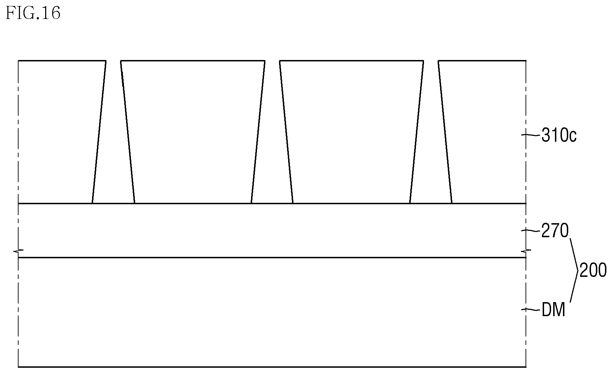

Referring to FIGS. 15 and 16, a light transmission pattern 310c is formed by exposing the light transmission material 310a to light, and developing the exposed light transmission material 310a. For example, a cured light transmission material 310b may be formed by exposing the light transmission material 310a to light. The operation of exposing the light transmission material 310a to light may include an operation of negatively exposing the light transmission material 310a using a mask M.

In the operation of negatively exposing the light transmission material 310a using the mask M, the mask M is located (or arranged) on (e.g., over) a desired or suitable area at (e.g., in or on) which the viewing angle controlling pattern 350 is to be formed, and ultraviolet rays L2 may be emitted toward the light transmission material 310a to form the cured light transmission material 310b.

Then, the light transmission material 310a of the cured light transmission material 310b is developed using a developing solution, and may be baked to form the light transmission pattern 310c. An opening is formed in the light transmission pattern 310c such that the top surface of the thin film encapsulation layer 270 may be exposed through the opening. The light transmission pattern 310c may be the same or substantially the same as the above-described light transmission pattern 310 of FIG. 7, and thus, redundant description thereof may not be repeated.

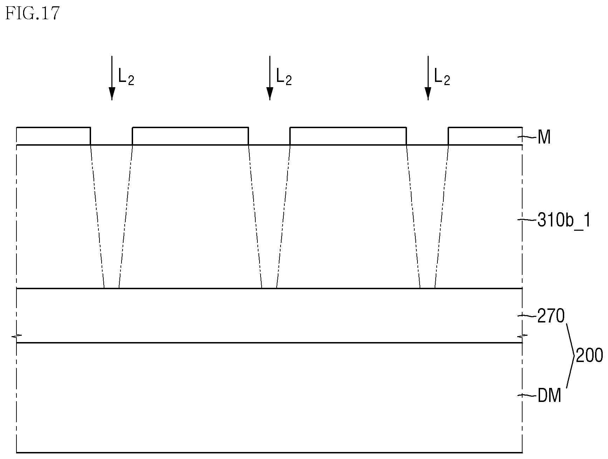

FIGS. 17 to 18 are cross-sectional views of a plurality of processing operations of a method of manufacturing a display according to an example. A light transmission material 310b_1 may be formed by exposing the light transmission material 310a to light. The operation of exposing the light transmission material 310a to light may include an operation of positively exposing the light transmission material 310a using a mask M.

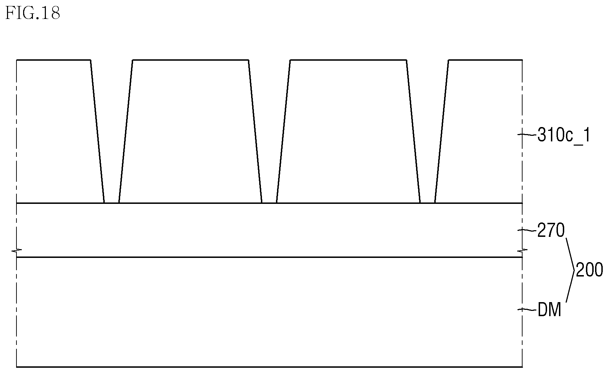

Referring to FIGS. 17 and 18, in the operation of positively exposing the light transmission material 310a using the mask M, the mask M is located (or arranged) on (e.g., over) a desired or suitable area at (e.g., in or on) which the viewing angle controlling pattern 350 is not to be formed, for example, an area at (e.g., in or on) which the light transmission pattern 310 is to be disposed, and ultraviolet rays L2 may be emitted toward the light transmission material 310a at (e.g., in or on) the area where the mask M is not located to form the light transmission material 310b_1.

Then, the light transmission material 310b_1 at the area where the mask M is not located is developed and removed, and the light transmission material 310a at the area where the mask M is located is baked such that a light transmission pattern 310c_1 of FIG. 18 may be formed. An opening is formed in the light transmission pattern 310c_1 such that the top surface of the thin film encapsulation layer 270 may be exposed through the opening. The light transmission pattern 310c_1 may be the same or substantially the same as the above-described light transmission pattern 310_1 of FIG. 8, and thus, redundant description thereof may not be repeated.

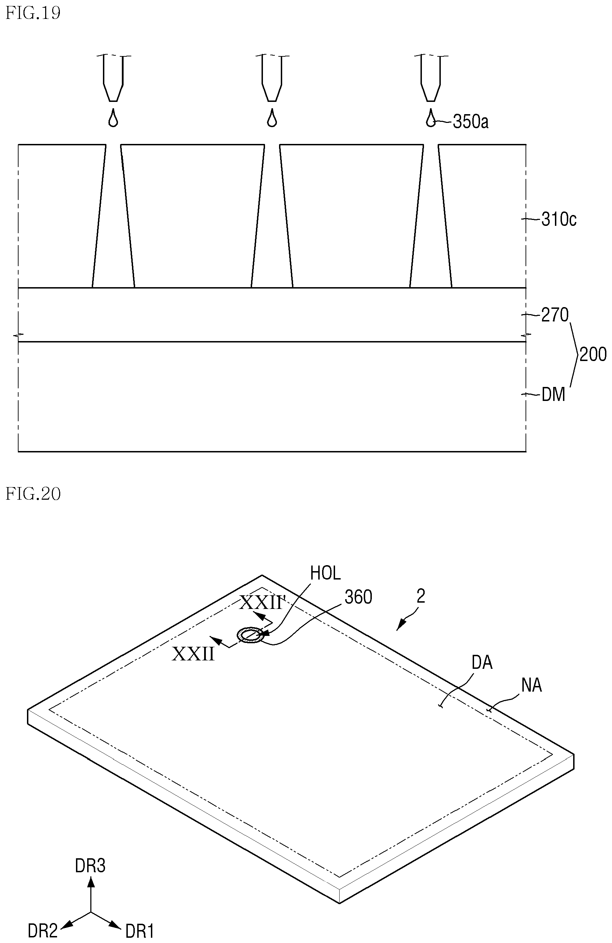

FIG. 19 is a cross-sectional view illustrating a processing operation of the method of manufacturing the display according to an example.

Referring to FIG. 19, a viewing angle controlling material 350a is formed between the light transmission patterns 310c.

The viewing angle controlling material 350a may include a light-barrier material, for example, such as a dark-colored pigment (e.g., a black pigment and/or a gray pigment), a dark-colored dye (e.g., a black dye and/or a gray dye), carbon black, a photoresist, and/or the like.

The operation of forming the viewing angle controlling material 350a between the light transmission patterns 310 may further include an operation of forming the viewing angle controlling material 350a between the light transmission patterns 310 through an inkjet process or through a filling process.

As used herein, the operation of forming the viewing angle controlling material 350a between the light transmission patterns 310 through the filling process refers to a process in which the viewing angle controlling material 350a is disposed at an edge part of the display 1, and a gap between the light transmission patterns 310 is filled with the viewing angle controlling material 350a through a capillary phenomenon.

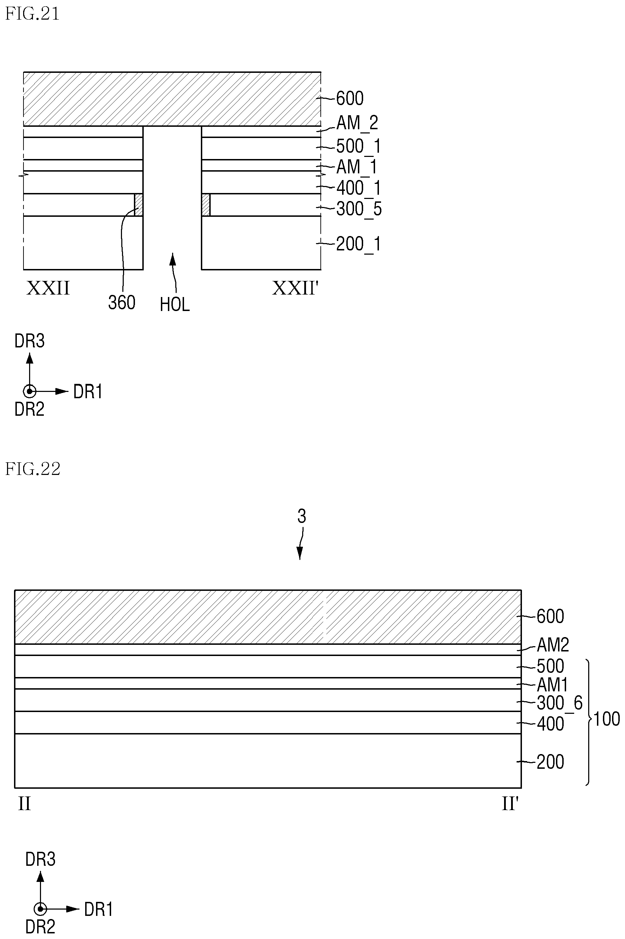

FIG. 20 is a perspective view of a display according to an embodiment, and FIG. 21 is a cross-sectional view of the display taken along the line XXII-XXII' of FIG. 20.

Referring to FIGS. 20 and 21, the embodiment shown may be different from the embodiment of FIGS. 1 and 3 in that the display 2 according to the embodiment of FIGS. 20 and 21 further includes a through-hole HOL that extends (e.g., passes) through each of a display member 200_1, a viewing angle controlling member 300_5, a touch member 400_1, and an optical film 500_1.

The through-hole HOL may be formed beginning from a second optically transparent adhesive member AM_2 and extending (e.g., passing) through each of the lower members thereof in a thickness direction.

The viewing angle controlling member 300_5 may further include a hole-peripheral pattern 360 that surrounds (e.g., around a periphery of) the through-hole HOL in a plan view. The hole-peripheral pattern 360 may be located at (e.g., on) a periphery of the through-hole HOL, and may completely surround (e.g., around the periphery of) the through-hole HOL in a plan view.

In some embodiments, as would be known to those skilled in the art, the viewing angle controlling member 300 shown in FIGS. 3 and 4 and the hole-peripheral pattern 360 may be disposed together.

FIG. 22 is a cross-sectional view of a display according to an embodiment different from the present invention.

Referring to FIG. 22, the embodiment shown is different from the embodiment of FIG. 2 in that a viewing angle controlling member 300_6 of the display 3 of FIG. 22 according to the embodiment is disposed between the touch member 400 and the first optically transparent adhesive member AM1.

The viewing angle controlling member 300_6 may be in contact (e.g., in direct contact) with the third touch insulating layer 450 of the touch member 400. When the third touch insulating layer 450 is omitted, the viewing angle controlling member 300_6 may be in contact (e.g., in direct contact) with the top surface of the second touch conductive layer 440. Other components and features in FIG. 22 are the same or substantially the same as those described above with reference to FIGS. 2 and 3, and thus, redundant description thereof may not be repeated.

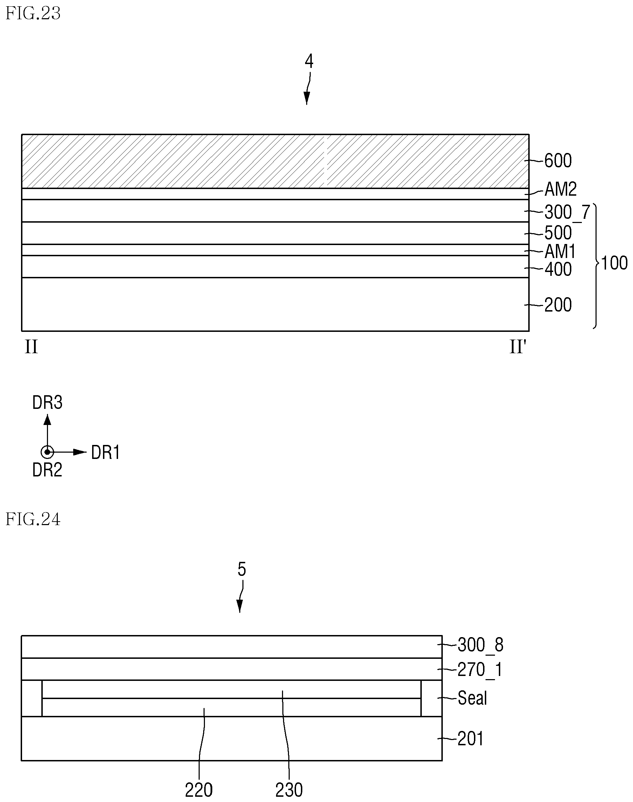

FIG. 23 is a cross-sectional view of a display according to an embodiment different from the present invention.

Referring to FIG. 23, the embodiment shown is different from the embodiment of FIG. 2 in that a viewing angle controlling member 300_7 of the display 4 in FIG. 23 according to the embodiment is disposed between the optical film 500 and the second optically transparent adhesive member AM2.

The viewing angle controlling member 300_7 may be disposed on (e.g., directly on) a top surface of the optical film 500. Other components and features of FIG. 23 are the same or substantially the same as those described above with reference to FIGS. 2 and 3, and thus, redundant description thereof may not be repeated.

FIG. 24 is a cross-sectional view of a display according to an embodiment.

Referring to FIG. 24, a display 5 according to the embodiment is different from the display 1 of FIGS. 2 and 3 in that a rigid display panel is applied.

In more detail, the display 5 according to the embodiment includes a lower substrate 201 and an upper substrate 270_1 opposite to the lower substrate 201. The display 5 may include a circuit driving layer 220 disposed between the lower substrate 201 and the upper substrate 270_1, and an organic light-emitting element layer 230 disposed between the circuit driving layer 220 and the upper substrate 270_1.

The lower substrate 201 and the upper substrate 270_1 may be rigid substrates. The upper substrate 270_1 may include, for example, glass, quartz, and/or the like. The upper substrate 270_1 may generally overlap with the lower substrate 201 as shown in FIG. 24. A sealing member Seal is disposed at (e.g., on) edges and at (e.g., on) outer parts of the upper substrate 270_1 and the lower substrate 201, and couples the upper substrate 270_1 with the lower substrate 201, but the present invention is not limited thereto. An edge part of the upper substrate 270_1 protrudes downward such that a protruding part of the upper substrate 270_1 may be coupled with the lower substrate 201 through a sealing member and/or the like.

The circuit driving layer 220 may include the TFT and the like described above with reference to FIGS. 2 and 3, and the organic light-emitting element layer 230 may include the light-emitting element ED and the like described above with reference to FIGS. 2 and 3. Other components and features of FIG. 24 are the same or substantially the same as those described above with reference to one or more embodiments, and thus, redundant description thereof may not be repeated.

A viewing angle controlling member 300_8 may be disposed on (e.g., directly on) a top surface of the upper substrate 270_1. Because the viewing angle controlling member 300_8 may be the same or substantially the same as those described above with reference to one or more embodiments, redundant description thereof may not be repeated.

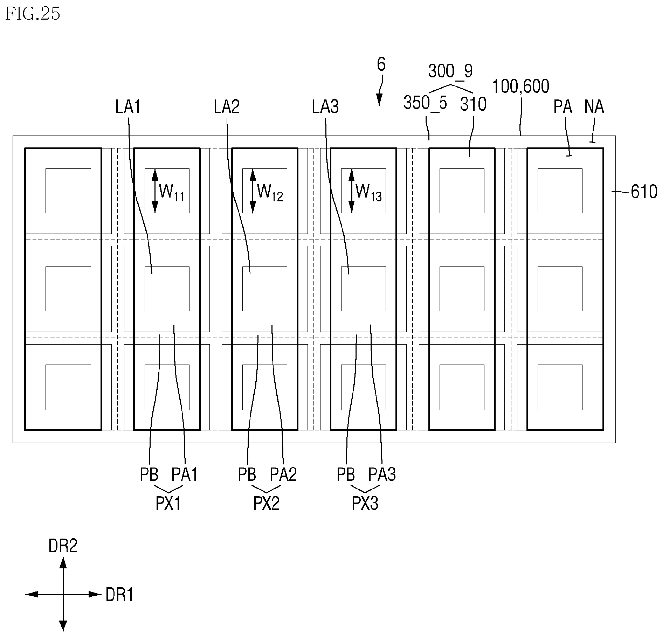

FIG. 25 is an arrangement plan view of a display according to an embodiment.

Referring to FIG. 25, in a display 6 according to the embodiment, a viewing angle controlling member 300_9 may be different from the viewing angle controlling member 300 of FIG. 4 in that a viewing angle controlling pattern 350_5 of the viewing angle controlling member 300_9 in FIG. 25 is disposed along the non-display area NA, for example, an edge (or a bezel) of the display 6, and has a stripe shape extending in the second direction DR2 crossing the first direction DR1.

Other components and features in FIG. 25 are the same or substantially the same as those described above with reference to FIG. 4, and thus, redundant description thereof may not be repeated.

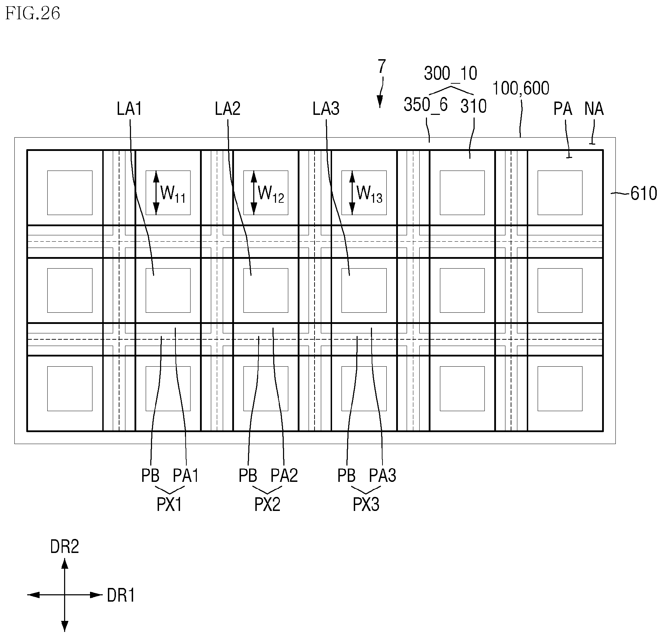

FIG. 26 is an arrangement plan view of a display according to an embodiment.

Referring to FIG. 26, in a display 7 according to the embodiment, a viewing angle controlling member 300_10 may be different from the viewing angle controlling member 300 of FIG. 4 in that a viewing angle controlling pattern 350_6 of the viewing angle controlling member 300_10 may be disposed along the non-display area NA, for example, an edge (or a bezel) of the display 7, and has a lattice shape extending in the first direction DR1 and the second direction DR2.

Other components and features in FIG. 26 are the same or substantially the same as those described above with reference to FIG. 4, and thus, redundant description thereof may not be repeated.

In a display according to one or more embodiments of the present invention and a method of manufacturing the same according to one or more examples useful for understanding the present disclosure, a viewing angle controlling pattern is embedded in a display panel so as to reduce a transmission loss.

In some embodiments, the viewing angle control pattern is disposed to not overlap with LEDs of the display panel so as to reduce a light loss.

In some embodiments, a degree of freedom in a shape of the viewing angle controlling pattern is increased.

## Claims

1. A display (1) comprising:
a display member (200) at which a plurality of pixels (PX1-PX3) is defined,
the display member (200) comprising a base substrate (201), a light-emitting element (ED) on the base substrate (201) at each pixel (PX1-PX3), and a thin film encapsulation layer (270) on the light-emitting element (ED);
a viewing angle controlling member (300) on the display member (200),
the viewing angle controlling member (300) comprising a plurality of viewing angle controlling patterns (350); and
a cover window (600) on the plurality of viewing angle controlling patterns (350),
wherein the plurality of viewing angle controlling patterns (350) is directly on the thin film encapsulation layer (270),
the display (1) further comprises:
a touch member (400), which is disposed on the plurality of viewing angle controlling patterns (350),
wherein the viewing angle controlling patterns (350) are embedded in a display panel (100); and
the display panel (100) comprising the display member (200),
**characterized in that**
the display (1) further comprises:
a through-hole (HOL) which extends completely through the display member (200), the viewing angle controlling member (300) and the touch member (400) in a thickness direction (DR3),
wherein the viewing angle controlling patterns (350) surround the through-hole (HOL), and wherein
a height of at least one of the viewing angle controlling patterns (350) is substantially equal to three times a pitch between adjacent ones of the viewing angle controlling patterns (350).

2. The display (1) of claim 1, wherein the light-emitting element (ED) comprises a first electrode (ANO) on the base substrate (201), a second electrode (CAT) opposite to the first electrode (ANO), and a light-emitting layer between the first electrode (ANO) and the second electrode (CAT), and
wherein each of the pixels (PX1-PX3) comprises a light-emitting area (LA1-LA3) at which a top surface of the first electrode (ANO) is partially exposed by a pixel definition film (PDL) on the first electrode (ANO), a non-emitting area is defined at a periphery of the light-emitting area (LA1-LA3), and each of the viewing angle controlling patterns (350) is at the non-emitting area.

3. The display (1) of claim 1 or 2, wherein each of the viewing angle controlling patterns (350) is positioned completely outside of a/the light-emitting area (LA1-LA3) of an adjacent pixel (PX1-PX3), when viewed in a plan view onto the display member (200).

4. The display (1) of at least one of claims 1 to 3, further comprising:
a polarization layer on the touch member (400).

5. The display (1) of at least one of claims 1 to 4, wherein the viewing angle controlling patterns (350) comprise at least one of a black-based dye, a black-based pigment, and a metal.

6. The display (1) of at least one of claims 1 to 5, wherein the viewing angle controlling member (300) further comprises a light transmission pattern (310) between adjacent ones of the viewing angle controlling patterns (350), the light transmission pattern (310) comprising a transparent photosensitive material.

7. The display (1) of at least one of claims 5 to 6, wherein the viewing angle controlling member (300) is between the touch member (400) and the polarization layer, or the viewing angle controlling member (300) is between the polarization layer and the cover window (600).

8. The display (1) of at least one of claims 1 to 7, wherein at least one of the viewing angle controlling patterns (350) has a forward-tapered shape, and an inclined angle (θ1) between a top surface of the thin film encapsulation layer (270) and a side surface of the at least one of the viewing angle controlling patterns (350) is within a range of 91° to 110°.

9. The display (1) of at least one of claims 1 to 7, wherein at least one of the viewing angle controlling patterns (350) has a reverse-tapered shape, and an inclined angle (θ2) between a top surface of the thin film encapsulation layer (270) and a side surface of the at least one of the viewing angle controlling patterns (350) is within a range of 85° to 89°.

10. The display (1) of at least one of claims 1 to 9, wherein a height of a surface of at least one of the viewing angle controlling patterns (350) is less than a height of a surface of the light transmission pattern (310).

11. The display (1) of claim 10, wherein the surface of the at least one of the viewing angle controlling patterns (350) includes a concave shape or a convex shape.

12. The display (1) of at least one of claims 1 to 9, wherein a height of a surface of at least one of the viewing angle controlling patterns (350) is greater than a height of a surface of the light transmission pattern (310), and the at least one of the viewing angle controlling patterns (350) partially covers a top surface of the light transmission pattern (310).

13. The display (1) of at least one of claims 1 to 12, wherein a height of the viewing angle controlling patterns (350) is greater than a width of a/the light-emitting area (LA1-LA3) of an adjacent pixel (PX1-PX3).

14. The display (1) of at least one of claims 1 to 13, wherein each of the pixels (PX1-PX3) comprises a light-exit area (PA1-PA3) comprising a/the light-emitting area (LA1-LA3) and a non-exit area (PB) at a periphery of the light-exit area (PA1-PA3),
wherein the display (1) further comprises a light-barrier pattern at the non-exit area (PB) on the cover window (600), and
wherein the light-barrier pattern overlaps with a corresponding one of the viewing angle controlling patterns (350) in a thickness direction (DR3).

15. The display (1) of at least one of claims 1 to 14, further comprising:
long-side edges extending in a first direction (DR1); and
short-side edges extending in a second direction (DR2) crossing the first direction (DR1),
wherein the plurality of viewing angle controlling patterns (350) has a stripe shape extending in the first direction (DR1).

16. The display (1) of claim 15, wherein the viewing angle controlling patterns (350) are continuously arranged on a border along the long-side edges and the short-side edges.

17. The display (1) of at least one of claims 1 to 14, further comprising:
long-side edges extending in a first direction (DR1); and
short-side edges extending in a second direction (DR2) crossing the first direction (DR1),
wherein the plurality of viewing angle controlling patterns (350) has a stripe shape extending in the second direction (DR2).

18. The display (1) of at least one of claims 1 to 14, further comprising:
long-side edges extending in a first direction (DR1); and
short-side edges extending in a second direction (DR2) crossing the first direction (DR1),
wherein the plurality of viewing angle controlling patterns (350) has a lattice shape extending in the first direction (DR1) and the second direction (DR2).

## Patentansprüche

1. Eine Anzeige (1), umfassend:
ein Anzeigeelement (200), an dem eine Vielzahl von Pixeln (PX1-PX3) definiert ist,
wobei das Anzeigeelement (200) ein Basissubstrat (201), ein lichtemittierendes Element (ED) auf dem Basissubstrat (201) an jedem Pixel (PX1-PX3), und eine Dünnschichtverkapselungsschicht (270) auf dem lichtemittierenden Element (ED) umfasst;
ein Betrachtungswinkel-Steuerungselement (300) auf dem Anzeigeelement (200),
wobei das Betrachtungswinkel-Steuerungselement (300) eine Vielzahl von Betrachtungswinkel-Steuerungsmustern (350) umfasst; und
ein Abdeckfenster (600) auf der Vielzahl von Betrachtungswinkel-Steuerungsmustern (350),
wobei die Vielzahl von Betrachtungswinkel-Steuerungsmustern (350) direkt auf der Dünnschichtverkapselungsschicht (270) ist,
die Anzeige (1) ferner umfassend:
ein Berührungselement (400), das auf der Vielzahl von Betrachtungswinkel-Steuerungsmustern (350) angeordnet ist,
wobei die Betrachtungswinkel-Steuerungsmuster (350) in ein Anzeigepanel (100) eingebettet sind; und
das Anzeigepanel (100) das Anzeigeelement (200) umfasst,
**dadurch gekennzeichnet, dass**
die Anzeige (1) ferner umfassend:
ein Durchgangsloch (HOL), das sich vollständig durch das Anzeigeelement (200), das Betrachtungswinkel-Steuerungselement (300) und das Berührungselement (400) in einer Dickenrichtung (DR3) erstreckt,
wobei die Betrachtungswinkel-Steuerungsmuster (350) das Durchgangsloch (HOL) umgeben, und wobei
eine Höhe von mindestens einem der Betrachtungswinkel-Steuerungsmuster (350) im Wesentlichen gleich dreimal einem Pitch zwischen benachbarten der Betrachtungswinkel-Steuerungsmuster (350) ist.

2. Die Anzeige (1) nach Anspruch 1, wobei das lichtemittierende Element (ED) eine erste Elektrode (ANO) auf dem Basissubstrat (201), eine zweite Elektrode (CAT) gegenüber der ersten Elektrode (ANO), und eine lichtemittierende Schicht zwischen der ersten Elektrode (ANO) und der zweiten Elektrode (CAT) umfasst, und
wobei jedes der Pixel (PX1-PX3) einen lichtemittierenden Bereich (LA1-LA3) umfasst, an dem eine obere Oberfläche der ersten Elektrode (ANO) teilweise durch einen Pixeldefinitionsfilm (PDL) auf der ersten Elektrode (ANO) freigelegt ist, ein nicht-emittierender Bereich an einer Peripherie des lichtemittierenden Bereichs (LA1-LA3) definiert ist, und jedes der Betrachtungswinkel-Steuerungsmuster (350) an dem nicht-emittierenden Bereich ist.

3. Die Anzeige (1) nach Anspruch 1 oder 2, wobei jedes der Betrachtungswinkel-Steuerungsmuster (350) vollständig außerhalb eines/dem lichtemittierenden Bereichs (LA1-LA3) eines benachbarten Pixels (PX1-PX3) positioniert ist, wenn in einer Draufsicht auf das Anzeigeelement (200) betrachtet.

4. Die Anzeige (1) nach mindestens einem der Ansprüche 1 bis 3, ferner umfassend:
eine Polarisationsschicht auf dem Berührungselement (400).

5. Die Anzeige (1) nach mindestens einem der Ansprüche 1 bis 4, wobei die Betrachtungswinkel-Steuerungsmuster (350) mindestens eines von einem schwarzbasierten Farbstoff, einem schwarzbasierten Pigment und einem Metall umfassen.

6. Die Anzeige (1) nach mindestens einem der Ansprüche 1 bis 5, wobei das Betrachtungswinkel-Steuerungselement (300) ferner ein Lichttransmissionsmuster (310) zwischen benachbarten der Betrachtungswinkel-Steuerungsmuster (350) umfasst, wobei das Lichttransmissionsmuster (310) ein transparentes lichtempfindliches Material umfasst.

7. Die Anzeige (1) nach mindestens einem der Ansprüche 5 bis 6, wobei das Betrachtungswinkel-Steuerungselement (300) zwischen dem Berührungselement (400) und der Polarisationsschicht ist, oder das Betrachtungswinkel-Steuerungselement (300) zwischen der Polarisationsschicht und dem Abdeckfenster (600) ist.

8. Die Anzeige (1) nach mindestens einem der Ansprüche 1 bis 7, wobei mindestens eines der Betrachtungswinkel-Steuerungsmuster (350) eine vorwärts-verjüngte Form hat, und ein Neigungswinkel (91) zwischen einer oberen Oberfläche der Dünnschichtverkapselungsschicht (270) und einer Seitenoberfläche des mindestens einen der Betrachtungswinkel-Steuerungsmuster (350) innerhalb eines Bereichs von 91° bis 110° ist.

9. Die Anzeige (1) nach mindestens einem der Ansprüche 1 bis 7, wobei mindestens eines der Betrachtungswinkel-Steuerungsmuster (350) eine rückwärts-verjüngte Form hat, und ein Neigungswinkel (92) zwischen einer oberen Oberfläche der Dünnschichtverkapselungsschicht (270) und einer Seitenoberfläche des mindestens einen der Betrachtungswinkel-Steuerungsmuster (350) innerhalb eines Bereichs von 85° bis 89° ist.

10. Die Anzeige (1) nach mindestens einem der Ansprüche 1 bis 9, wobei eine Höhe einer Oberfläche von mindestens einem der Betrachtungswinkel-Steuerungsmuster (350) kleiner ist als eine Höhe einer Oberfläche des Lichttransmissionsmusters (310).

11. Die Anzeige (1) nach Anspruch 10, wobei die Oberfläche des mindestens einen der Betrachtungswinkel-Steuerungsmuster (350) eine konkave Form oder eine konvexe Form umfasst.

12. Die Anzeige (1) nach mindestens einem der Ansprüche 1 bis 9, wobei eine Höhe einer Oberfläche von mindestens einem der Betrachtungswinkel-Steuerungsmuster (350) größer ist als eine Höhe einer Oberfläche des Lichttransmissionsmusters (310), und das mindestens eine der Betrachtungswinkel-Steuerungsmuster (350) teilweise eine obere Oberfläche des Lichttransmissionsmusters (310) bedeckt.

13. Die Anzeige (1) nach mindestens einem der Ansprüche 1 bis 12, wobei eine Höhe der Betrachtungswinkel-Steuerungsmuster (350) größer ist als eine Breite eines lichtemittierenden Bereichs (LA1-LA3) eines benachbarten Pixels (PX1-PX3).

14. Die Anzeige (1) nach mindestens einem der Ansprüche 1 bis 13, wobei jedes der Pixel (PX1-PX3) einen Lichtaustrittsbereich (PA1-PA3) umfasst, der einen lichtemittierenden Bereich (LA1-LA3) und einen Nicht-Austrittsbereich (PB) an einer Peripherie des Lichtaustrittsbereichs (PA1-PA3) umfasst,
wobei die Anzeige (1) ferner ein Lichtbarrieremuster an dem Nicht-Austrittsbereich (PB) auf dem Abdeckfenster (600) umfasst, und
wobei das Lichtbarrieremuster mit einem entsprechenden der Betrachtungswinkel-Steuerungsmuster (350) in einer Dickenrichtung (DR3) überlappt.

15. Die Anzeige (1) nach mindestens einem der Ansprüche 1 bis 14, ferner umfassend:
Langseitenkanten, die sich in einer ersten Richtung (DR1) erstrecken; und
Kurzseitenkanten, die sich in einer zweiten Richtung (DR2) erstrecken, die die erste Richtung (DR1) kreuzt,
wobei die Vielzahl von Betrachtungswinkel-Steuerungsmustern (350) eine Streifenform hat, die sich in der ersten Richtung (DR1) erstreckt.

16. Die Anzeige (1) nach Anspruch 15, wobei die Betrachtungswinkel-Steuerungsmuster (350) kontinuierlich an einem Rand entlang der Langseitenkanten und der Kurzseitenkanten angeordnet sind.

17. Die Anzeige (1) nach mindestens einem der Ansprüche 1 bis 14, ferner umfassend:
Langseitenkanten, die sich in einer ersten Richtung (DR1) erstrecken; und
Kurzseitenkanten, die sich in einer zweiten Richtung (DR2) erstrecken, die die erste Richtung (DR1) kreuzt,
wobei die Vielzahl von Betrachtungswinkel-Steuerungsmustern (350) eine Streifenform hat, die sich in der zweiten Richtung (DR2) erstreckt.

18. Die Anzeige (1) nach mindestens einem der Ansprüche 1 bis 14, ferner umfassend:
Langseitenkanten, die sich in einer ersten Richtung (DR1) erstrecken; und
Kurzseitenkanten, die sich in einer zweiten Richtung (DR2) erstrecken, die die erste Richtung (DR1) kreuzt,
wobei die Vielzahl von Betrachtungswinkel-Steuerungsmustern (350) eine Gitterform hat, die sich in der ersten Richtung (DR1) und der zweiten Richtung (DR2) erstreckt.

## Revendications

1. Afficheur (1) comprenant :
un élément d'affichage (200) au niveau duquel une pluralité de pixels (PX1-PX3) est définie,
l'élément d'affichage (200) comprenant un substrat de base (201), un élément électroluminescent (ED) sur le substrat de base (201) au niveau de chaque pixel (PX1-PX3), et une couche d'encapsulation de film mince (270) sur l'élément électroluminescent (ED) ;
un élément de commande d'angle de visualisation (300) sur l'élément d'affichage (200),
l'élément de commande d'angle de visualisation (300) comprenant une pluralité de motifs de commande d'angle de visualisation (350) ; et
une fenêtre de couverture (600) sur la pluralité de motifs de commande d'angle de visualisation (350),
dans lequel la pluralité de motifs de commande d'angle de visualisation (350) se trouve directement sur la couche d'encapsulation de film mince (270),
l'afficheur (1) comprend en outre :
un élément tactile (400) qui est disposé sur la pluralité de motifs de commande d'angle de visualisation (350),
dans lequel les motifs de commande d'angle de visualisation (350) sont incorporés dans un panneau d'affichage (100) ; et
le panneau d'affichage (100) comprenant l'élément d'affichage (200),
**caractérisé en ce que**
l'afficheur (1) comprend en outre :
un trou traversant (HOL) qui s'étend à travers l'élément d'affichage (200), l'élément de commande d'angle de visualisation (300) et l'élément tactile (400) dans une direction d'épaisseur (DR3),
dans lequel les motifs de commande d'angle de visualisation (350) entourent le trou traversant (HOL), et dans lequel une hauteur d'au moins un parmi les motifs de commande d'angle de visualisation (350) est sensiblement égale à trois fois un pas entre des motifs adjacents parmi les motifs de commande d'angle de visualisation (350).

2. Afficheur (1) selon la revendication 1, dans lequel l'élément électroluminescent (ED) comprend une première électrode (ANO) sur le substrat de base (201), une deuxième électrode (CAT) opposée à la première électrode (ANO), et une couche électroluminescente entre la première électrode (ANO) et la deuxième électrode (CAT), et
dans lequel chacun des pixels (PX1-PX3) comprend une zone électroluminescente (LA1-LA3) au niveau de laquelle une surface supérieure de la première électrode (ANO) est exposée partiellement par un film de définition de pixels (PDL) sur la première électrode (ANO), une zone non-électroluminescente est définie au niveau d'une périphérie de la zone électroluminescente (LA1-LA3), et chacun des motifs de commande d'angle de visualisation (350) se trouve au niveau de la zone non-électroluminescente.

3. Afficheur (1) selon la revendication 1 ou 2, dans lequel chacun des motifs de commande d'angle de visualisation (350) est positionné complètement à l'extérieur d'une ou de la zone électroluminescente (LA1-LA3) d'un pixel adjacent (PX1-PX3), lorsqu'il est vu dans une vue en plan sur l'élément d'affichage (200).

4. Afficheur (1) selon au moins l'une des revendications 1 à 3, comprenant en outre :
une couche de polarisation sur l'élément tactile (400).

5. Afficheur (1) selon au moins l'une des revendications 1 à 4, dans lequel les motifs de commande d'angle de visualisation (350) comprennent au moins un parmi une tenture à base de noir, d'un pigment à base de noir et d'un métal.

6. Afficheur (1) selon au moins l'une des revendications 1 à 5, dans lequel l'élément de commande d'angle de visualisation (300) comprend en outre un motif de transmission de lumière (310) entre des motifs adjacents parmi les motifs de commande d'angle de visualisation (350), le motif de transmission de lumière (310) comprenant un matériau photosensible transparent.

7. Afficheur (1) selon au moins l'une des revendications 5 à 6, dans lequel l'élément de commande d'angle de visualisation (300) se trouve entre l'élément tactile (400) et la couche de polarisation, ou l'élément de commande d'angle de visualisation (300) se trouve entre la couche de polarisation et la fenêtre de couverture (600).

8. Afficheur (1) selon au moins l'une des revendications 1 à 7, dans lequel au moins un parmi les motifs de commande d'angle de visualisation (350) présente une forme effilée vers l'avant, et un angle incliné (θ1) entre une surface supérieure de la couche d'encapsulation de film mince (270) et une surface latérale de l'au moins un parmi les motifs de commande d'angle de visualisation (350) est dans une plage allant de 91° à 110°.

9. Afficheur (1) selon au moins l'une des revendications 1 à 7, dans lequel au moins un parmi les motifs de commande d'angle de visualisation (350) présente une forme effilée en sens inverse, et un angle incliné (θ2) entre une surface supérieure de la couche d'encapsulation de film mince (270) et une surface latérale de l'au moins un parmi les motifs de commande d'angle de visualisation (350) est dans une plage allant de 85° à 89°.

10. Afficheur (1) selon au moins l'une des revendications 1 à 9, dans lequel une hauteur d'une surface d'au moins un parmi les motifs de commande d'angle de visualisation (350) est plus petite qu'une hauteur d'une surface du motif de transmission de lumière (310).

11. Afficheur (1) selon la revendication 10, dans lequel la surface de l'au moins un parmi les motifs de commande d'angle de visualisation (350) comporte une forme concave ou une forme convexe.

12. Afficheur (1) selon au moins l'une des revendications 1 à 9, dans lequel une hauteur d'une surface d'au moins un parmi les motifs de commande d'angle de visualisation (350) est plus grande qu'une hauteur d'une surface du motif de transmission de lumière (310), et l'au moins un parmi les motifs de commande d'angle de visualisation (350) recouvre partiellement une surface supérieure du motif de transmission de lumière (310).

13. Afficheur (1) selon au moins l'une des revendications 1 à 12, dans lequel une hauteur des motifs de commande d'angle de visualisation (350) est plus grande qu'une largeur d'une ou de la zone électroluminescente (LA1-LA3) d'un pixel adjacent (PX1-PX3).

14. Afficheur (1) selon au moins l'une des revendications 1 à 13, dans lequel chacun des pixels (PX1-PX3) comprend une zone de sortie de lumière (PA1-PA3) comprenant une ou la zone électroluminescente (LA1-LA3) et une zone de non-sortie (PB) au niveau d'une périphérie de la zone de sortie de lumière (PA1-PA3), dans lequel l'afficheur (1) comprend en outre un motif de barrière à la lumière au niveau de la zone de non-sortie (PB) sur la fenêtre de couverture (600), et
dans lequel le motif de barrière à la lumière chevauche un motif correspondant parmi les motifs de commande d'angle de visualisation (350) dans une direction d'épaisseur (DR3).

15. Afficheur (1) selon au moins l'une des revendications 1 à 14, comprenant en outre :
des bords latéraux longs s'étendant dans une première direction (DR1) ; et
des bords latéraux courts s'étendant dans une deuxième direction (DR2) intersectant la première direction (DR1),
dans lequel la pluralité de motifs de commande d'angle de visualisation (350) présente une forme en bande s'étendant dans la première direction (DR1).

16. Afficheur (1) selon la revendication 15, dans lequel les motifs de commande d'angle de visualisation (350) sont disposés en continu sur une bordure le long des bords latéraux longs et des bords latéraux courts.

17. Afficheur (1) selon au moins l'une des revendications 1 à 14, comprenant en outre :
des bords latéraux longs s'étendant dans une première direction (DR1) ; et
des bords latéraux courts s'étendant dans une deuxième direction (DR2) intersectant la première direction (DR1),
dans lequel la pluralité de motifs de commande d'angle de visualisation (350) présente une forme en bande s'étendant dans la deuxième direction (DR2).

18. Afficheur (1) selon au moins l'une des revendications 1 à 14, comprenant en outre :
des bords latéraux longs s'étendant dans une première direction (DR1) ; et
des bords latéraux courts s'étendant dans une deuxième direction (DR2) intersectant la première direction (DR1),
dans lequel la pluralité de motifs de commande d'angle de visualisation (350) présente une forme en réseau s'étendant dans la première direction (DR1) et la deuxième direction (DR2).
